# EUROPEAN PATENT SPECIFICATION

(11) **EP 2 752 443 B1**
(45) Date of publication and mention of the grant of the patent: **16.05.2018**
(21) Application number: 12826958.6
(22) Date of filing: 21.08.2012
(51) Int. Cl.: C08J 5/18, H01L 31/042, C08L 79/08, C08K 3/34

(54) **VAPOR BARRIER FILM, DISPERSION FOR VAPOR BARRIER FILM, METHOD FOR PRODUCING VAPOR BARRIER FILM, SOLAR CELL BACK SHEET, AND SOLAR CELL**
DAMPFBREMSFOLIE, DISPERSION FÜR DIE DAMPFBREMSFOLIE, VERFAHREN ZUR HERSTELLUNG DER DAMPFBREMSFOLIE, RÜCKSEITENFOLIE FÜR SOLARZELLEN UND SOLARZELLE
FILM PARE-VAPEUR, DISPERSION POUR FILM PARE-VAPEUR, PROCÉDÉ DE PRODUCTION D'UN FILM PARE-VAPEUR, COUCHE ARRIÈRE POUR PILE PHOTOVOLTAÏQUE ET PILE PHOTOVOLTAÏQUE

(30) Priority: 29.08.2011 JP 2011186506; 31.07.2012 JP 2012170039
(43) Date of publication of application: 09.07.2014
(73) Proprietor: Sumitomo Seika Chemicals Co., Ltd., Kako-gun Hyogo 675-0145 (JP); National Institute of Advanced Industrial Science and Technology, Tokyo 100-8921 (JP)
(72) Inventor: BANDO, Seiji, Kako-gun Hyogo 675-0145 (JP); MISHO, Daisuke, Kako-gun Hyogo 675-0145 (JP); KAWASAKI, Kazunori, Sendai-shi Miyagi 983-8551 (JP); EBINA, Takeo, Sendai-shi Miyagi 983-8551 (JP); HAYASHI, Hiromichi, Sendai-shi Miyagi 983-8551 (JP); NAKAMURA, Takashi, Sendai-shi Miyagi 983-8551 (JP); YOSHIDA, Manabu, Tsukuba-shi Ibaraki 305-8565 (JP)
(74) Representative: Webster, Jeremy Mark
(86) International application number: PCT/JP2012/071062
(87) International publication number: WO 2013/031578

(56) References cited:
- JP-A- H11 343 409
- JP-A- H11 343 409
- JP-A- 2003 313 322
- JP-A- 2005 194 415
- JP-A- 2007 277 078
- JP-A- 2011 001 237

## Description

### TECHNICAL FIELD

The present invention relates to a water vapor barrier film having high mechanical strength, good flexibility, good flame retardancy, and good water vapor barrier performance. The present invention also relates to a dispersion for water vapor barrier films which is intended to be used to produce the water vapor barrier film, a method for producing the water vapor barrier film, a solar cell back sheet incorporating the water vapor barrier film, and a solar cell incorporating the water vapor barrier film or the solar cell back sheet.

### BACKGROUND ART

A recent trend towards miniaturization, thinning, and sophistication in the fields of electronic devices has created a desire for a flexible, sophisticated film having excellent properties including heat resistance, chemical resistance, hydrolysis resistance, flame retardancy, non-combustibility, dimensional stability, and water vapor barrier performance.

Conventional films for electronic devices mostly include a substrate made of an organic polymer material. A common film having gas barrier performance includes a polymer resin film substrate and a gas barrier layer on one or both of the surfaces of the polymer resin film substrate. Such a gas barrier layer is made of, for example, aluminum oxide, silicon oxide, or silicon nitride, and can be formed by various techniques such as CVD and PVD.

Examples of heat-resistant films developed so far are films made of fluororesin or thin glass sheets. Unfortunately, fluororesin is expensive, and gives poor dimensional stability and poor water vapor barrier performance. Additionally, the maximum service temperature of fluororesin is as low as about 200°C, which means that it cannot withstand use at high temperatures. Among organic polymer materials, engineering plastics have the highest heat resistance of about 350°C. Even these plastics cannot be used for applications requiring gas barrier performance and water vapor barrier performance at further higher temperatures. On the other hand, thin glass sheets are inexpensive, and have very good heat resistance and water vapor barrier performance, but are not flexible enough. For these reasons, inorganic sheets and metal sheets have been used as materials having gas barrier performance and water vapor barrier performance at high temperatures.

Inorganic sheets are sheets manufactured by processing natural or synthetic minerals, such as mica or vermiculite. These sheets have high heat resistance, and have been used for gland packings to exhibit acceptable performance as gas sealing members. Unfortunately, these inorganic sheets fail to completely block paths through which small gas molecules flow because it is difficult to produce these sheets as dense sheets. Namely, their gas barrier performance is not good enough. In addition, their flexibility is poor.

On the other hand, metal sheets have good gas barrier performance, but are poor in, for example, weather resistance, electric insulation properties, and chemical resistance. These disadvantages limit the range of their applications. For applications under severe environment, for example, as protective films or back sheets for solar cells or other devices, films having the following properties are required, for example: weather resistance (e.g. ultraviolet resistance, moisture resistance, heat resistance, salt corrosion resistance); water vapor barrier performance; electric insulation properties; mechanical strength; chemical resistance; and adhesion to sealing materials. Also required are films that have gas barrier performance even under severer environment compared to conventional materials.

Generally used plastic films such as polyimide films are flexible, but have poor water vapor barrier performance and poor heat resistance. Many attempts have therefore been made in recent years to produce more sophisticated films by mixing a synthetic resin with an inorganic compound. Addition of an inorganic compound in an increasing amount surely achieves better heat resistance, but decreases the flexibility and mechanical strength. It has been thus difficult to produce a film having good flexibility, good water vapor barrier performance, and high mechanical strength.

There are reports on films produced from a mixture of a polyimide resin and an inorganic compound such as clay. Usually, such an inorganic compound is not homogeneously mixed with a polyimide resin, and is separated to provide an inhomogeneous film. Patent Literatures 1 to 4 teach films obtained from a homogeneous dispersion of polyimide and inorganic compounds, using a clay additive, the interlayer ions of which are substituted by an organic ion. Since the clay contains an organic material, the resulting films have a defect of low heat resistance which causes the films to be burnt when exposed to flame. A further disadvantage is insufficient water vapor barrier performance.

Patent Literatures 5 and 6 teach films produced using a dilute dispersion for films which contains nonvolatile components in a proportion of 5% by weight or less of the total weight of the dispersion. These techniques, however, provide films mainly composed of organic components with an inorganic compound content of 8% by weight or less of the total nonvolatile components. Such films have poor heat resistance.

Patent Literatures 7 and 8 disclose films having an inorganic compound content of 80% by weight or more of the total nonvolatile components. These films, however, are easily torn, have low mechanical strength and low handleability, and thus are difficult to handle. Additionally, it is difficult to produce thicker films by these techniques. Films having a thickness of 40 µm or more develop cracks or break in the process of production.

Patent Literature 9 teaches a technique of using a polyurethane adhesive with increased durability, as determined by an accelerated test at 85°C and 85%RH, in a solar cell back sheet which is a laminate of at least two substrates attached with a polyurethane adhesive.

Still, the use of an adhesive causes the resulting back sheet to have insufficient durability even if the durability of the adhesive is improved by the technique of Patent Literature 9.

JP Hll-343409 A concerns a polyamide resin composition produced by uniformly dispersing (A) 1-20 wt.% of a phyllosilicate having 0.5-10 nm average layer thickness and 10-500 average aspect ratio and (B) 1-40 wt.% of a nonfibrous inorganic filler having 0.05-25 µm average particle diameter and 5-20 average aspect ratio in (C) a polyamide resin.

### CITATION LIST

### - Patent Literature

Patent Literature 1: JP 2003-340919 A
Patent Literature 2: JP 2002-322292 A
Patent Literature 3: JP 2003-342471 A
Patent Literature 4: Japanese Patent No. 3744634
Patent Literature 5: JP 2010-533213 T
Patent Literature 6: JP 2010-533362 T
Patent Literature 7: JP 2006-77237 A
Patent Literature 8: JP 2011-1237 A
Patent Literature 9: JP 2008-4691 A

### SUMMARY OF INVENTION

### - Technical Problem

An object of the present invention is to provide a water vapor barrier film having high mechanical strength, good flexibility, good flame retardancy, and good water vapor barrier performance. A further object of the present invention is to provide a dispersion for water vapor barrier films which is intended to be used to produce the water vapor barrier film, a method for producing the water vapor barrier film, a solar cell back sheet incorporating the water vapor barrier film, and a solar cell incorporating the water vapor barrier film or the solar cell back sheet.

### - Solution to Problem

The present invention provides a water vapor barrier film containing a phyllosilicate mineral and a synthetic resin, wherein the phyllosilicate mineral includes a non-swelling clay mineral and a swelling clay mineral, the phyllosilicate mineral is present in an amount of not less than 30% by weight and not more than 90% by weight of the total weight of the water vapor barrier film, and the water vapor barrier film has a water vapor permeability, measured at 40°C and 90%RH, of not more than 0.5 g/m²·day, the non-swelling clay mineral has a swelling force of less than 5 mL/2 g and the swelling clay mineral has a swelling force of not less than 5 mL/2 g, the swelling force being measured according to the measurement method as set out in the description, the swelling clay mineral is present in an amount of not less than 2% by weight and not more than 80% by weight of the total weight of the phyllosilicate mineral, and the synthetic resin is a heat-resistant synthetic resin.

The following description is offered to illustrate the present invention.

The present inventors found out that the use of a specific amount of a phyllosilicate mineral containing a non-swelling clay mineral and a swelling clay mineral results in a water vapor barrier film having high mechanical strength, good flexibility, good flame retardancy, and good water vapor barrier performance. Thus, the present invention was completed.

Conventional water vapor barrier films contain a swelling clay mineral, which confers water vapor barrier performance. Swelling clay minerals contain ions between layers. It is known that because of their interlayer ions, swelling clay minerals swell and delaminate in a dispersion medium, and layers are gradually formed on one another while the dispersion medium is removed. This structure exhibits barrier performance against gases such as water vapor. Unfortunately, it is difficult to prepare a homogeneous dispersion for films containing a swelling clay mineral (e.g. composite films containing a swelling clay mineral, a non-swelling clay mineral, and a synthetic resin), and this makes it difficult to produce homogeneous films. A further disadvantage is that thick films containing a swelling clay mineral are generally difficult to produce. Such films develop cracks or break in the process of production. Specifically, films with a thickness of 40 µm or more are difficult to produce.

Additionally, it is difficult to form films with high water vapor barrier performance from a non-swelling clay mineral because general non-swelling clay minerals cannot be formed into films with highly oriented plate-like crystals. To defeat the above problems, the present inventors found a way to prepare a homogenous dispersion containing specific amounts of a swelling clay mineral and a non-swelling clay mineral by a specific mixing technique. Another finding is that the use of a non-swelling clay mineral alone does not provide a film with highly oriented plate-like crystals, but the use of this homogeneous dispersion surprisingly results in a film in which crystals of all clay minerals including the non-swelling clay mineral are highly oriented, and the resulting film has high water vapor barrier performance. These findings enabled the inventors to develop a water vapor barrier film having high mechanical strength, good flexibility, good flame retardancy, and good water vapor barrier performance.

The water vapor barrier film of the present invention contains a phyllosilicate mineral.

The water vapor barrier film of the present invention contains a non-swelling clay mineral and a swelling clay mineral as the phyllosilicate mineral.

The term "non-swelling" herein means that a material hardly swells with the addition of water or an organic solvent. Specifically, it refers to a swelling force of less than 5 mL/2 g.

The "swelling force" is measured based on the method for measuring the swelling force of bentonite (powder) (JBAS-104-77) in the standard tests of the Japan Bentonite Manufacturers Association, specifically by: adding 2.0 g of clay mineral powder by portions in 100 mL of water in a 100-mL measuring cylinder to sediment spontaneously; and reading the apparent volume of the swelling clay mineral.

Without the non-swelling clay mineral, the swelling clay mineral with a swelling force of not less than 5 mL/2 g alone cannot be dispersed well in a dispersion medium, and this results in a film with uneven surfaces. The preferable upper limit of the swelling force of the non-swelling clay mineral is 4 mL/2 g, and the more preferable upper limit is 3 mL/2 g. The preferable lower limit is, but not particularly limited to, 0.5 mL/2 g for practical reasons.

Examples of the non-swelling clay mineral include natural or synthetic mica, talc, kaolin, and pyrophyllite. In particular, clay minerals with no layer charge are preferable in terms of the mechanical strength and water vapor barrier performance of the resulting film. More preferred is at least one selected from the group consisting of talc, kaolin, and pyrophyllite. Any of these non-swelling clay minerals may be used alone, or two or more of these may be used in combination.

The term "swelling" herein means that a material swells with the addition of water or an organic solvent. The swelling clay mineral contains ions, such as sodium ion, between layers. The affinity of these ions for the solvent causes the swelling clay mineral to swell. Specifically, the term refers to a "swelling force", determined as described above, of not less than 5 mL/2 g.

The use of the non-swelling clay mineral with a swelling force of less than 5 mL/2 g alone without the swelling clay mineral results in a film in which the clay mineral is poorly laminated. Such a film has high water vapor permeability. The preferable lower limit of the swelling force of the swelling clay mineral is 18 mL/2 g, the more preferable lower limit is 50 mL/2 g, and the still more preferable lower limit is 80 mL/2 g. The preferable upper limit is, but not particularly limited to, 105 mL/2 g for practical reasons.

Examples of the swelling clay mineral include vermiculite, montmorillonite, beidellite, saponite, hectorite, stevensite, magadiite, ilerite, kanemite, illite, and sericite. Examples of commercial products include SOMASIF (Co-op Chemical Co., Ltd.) and Kunipia (KUNIMINE INDUSTRIES CO., LTD.), and Kunipia is preferably used. In particular, clay minerals with a layer charge per 1/2 unit cell of 0.2 to 0.6 are preferable in terms of the smoothness and water vapor barrier performance of the resulting film. More preferred is at least one selected from the group consisting of montmorillonite, saponite, hectorite, and stevensite. Any of these swelling clay minerals may be used alone, or two or more of these may be used in combination.

The swelling clay mineral is preferably modified with a silylating agent. This reaction is aimed to improve the dispersibility in the dispersion.

Examples of the silylating agent include methyltrimethoxysilane, methyltriethoxysilane, propyltrimethoxysilane, butyltrimethoxysilane, hexyltrimethoxysilane, octyltrimethoxysilane, dodecyltrimethoxysilane, and octadecyltrimethoxysilane.

Preferably, the interlayer cations of the swelling clay mineral are substituted by another cation to improve the swelling property and water resistance.

The interlayer cations are preferably substituted by, for example, a metal ion, such as sodium ion, lithium ion, magnesium ion, potassium ion, or calcium ion; an onium ion, such as an ammonium ion compound or a phosphonium ion compound; or hydrogen ion. The interlayer cations are more preferably substituted by a monovalent ion, such as sodium ion, lithium ion, potassium ion, an ammonium ion compound, a phosphonium ion compound, or hydrogen ion. Substitution by lithium ion is still more preferable because of its effect of improving the water resistance.

Preferably, the particle size of the phyllosilicate mineral is considered to select the phyllosilicate mineral because the properties of the resulting water vapor barrier film depend also on the average particle size of the phyllosilicate mineral.

The preferable lower limit of the average particle size of the swelling clay mineral is 0.01 µm, and the preferable upper limit is 50 µm. If the average particle size of the swelling clay mineral is less than 0.01 µm, the clay mineral is poorly laminated in the film. This may increase the water vapor permeability. If the average particle size of the swelling clay mineral is more than 50 µm, the resulting film may have uneven surfaces. The more preferable lower limit of the average particle size of the swelling clay mineral is 0.05 µm, and the more preferable upper limit is 20 µm. The still more preferable lower limit is 0.1 µm, and the still more preferable upper limit is 15 µm.

The preferable lower limit of the average particle size of the non-swelling clay mineral is 0.1 µm, and the preferable upper limit is 50 µm. If the average particle size of the non-swelling clay mineral is less than 0.1 µm, the resulting film may have poor mechanical strength. If the average particle size of the non-swelling clay mineral is more than 50 µm, the resulting film may have uneven surfaces. The more preferable lower limit of the average particle size of the non-swelling clay mineral is 0.2 µm, and the more preferable upper limit is 20 µm. The still more preferable lower limit is 0.5 µm, and the still more preferable upper limit is 15 µm.

The average particle size of the swelling clay mineral and the non-swelling clay mineral can be determined by measuring the particle size distribution using an instrument such as a laser diffraction particle size analyzer.

The lower limit of the amount of the phyllosilicate mineral is 30% by weight of the total weight of the water vapor barrier film, and the upper limit is 90% by weight. If the amount of the phyllosilicate mineral is less than 30% by weight, the resulting film may have poor heat resistance as well as high water vapor permeability. If the amount of the phyllosilicate mineral is more than 90% by weight, the resulting film may have poor mechanical strength. The preferable lower limit of the amount of the phyllosilicate mineral is 35% by weight, and the preferable upper limit is 85% by weight. The more preferable lower limit is 40% by weight, and the more preferable upper limit is 80% by weight. The still more preferable lower limit is 50% by weight, and the still more preferable upper limit is 70% by weight. The lower limit is particularly preferably 60% by weight.

The lower limit of the amount of the swelling clay mineral is 2% by weight of the total weight of the phyllosilicate mineral, and the upper limit is 80% by weight. If the amount of the swelling clay mineral is less than 2% by weight, the resulting film may have high water vapor permeability. If the amount of the swelling clay mineral is more than 80% by weight, the resulting film may have poor mechanical strength. The more preferable lower limit of the amount of the swelling clay mineral is 5% by weight, and the more preferable upper limit is 70% by weight. The still more preferable lower limit is 10% by weight, and the still more preferable upper limit is 60% by weight. The particularly preferable lower limit is 20% by weight, and the particularly preferable upper limit is 50% by weight.

In other words, the ratio of the non-swelling clay mineral to the swelling clay mineral is preferably (98:2) to (20:80) on a weight basis. If the proportion of the non-swelling clay mineral is less than 20%, the resulting film may have poor mechanical strength. If the proportion of the non-swelling clay mineral is more than 98%, the resulting film may have high water vapor permeability.

The water vapor barrier film of the present invention contains a synthetic resin.

The synthetic resin is a heat-resistant synthetic resin, and preferably a super engineering plastic in terms of the heat resistance.

Examples of heat-resistant synthetic resins include polyimide resins, polyamide-imide resins, fluororesins, polyphenylene sulfide resins, polysulfone resins, polyarylate resins, polyethersulfone resins, polyetherimide resins, polyetheretherketone resins, polybenzoxazole resins, and polybenzimidazole resins. Particularly preferred is/are a polyimide resin and/or a polyamide-imide resin, which facilitate production of a non-combustible film, and confer excellent heat resistance, and excellent mechanical strength on the resulting non-combustible film.

The polyimide resin refers to compounds having repeating units represented by the following formula (1), and the polyamide-imide resins refers to compounds having repeating units represented by the following formula (2).

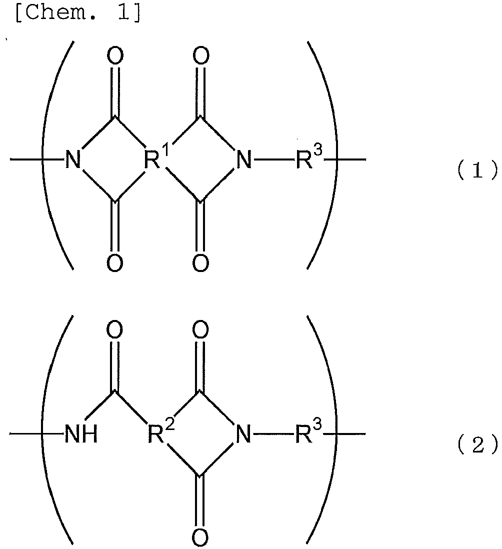

In formula (1), R¹ is a tetravalent organic group having one or two benzene rings. R¹ is preferably any of the moieties represented by the following formulas (3). The polyimide resin may have one of the moieties represented by formulas (3) as R¹, or may be a copolymer having at least two of these moieties as R¹s.

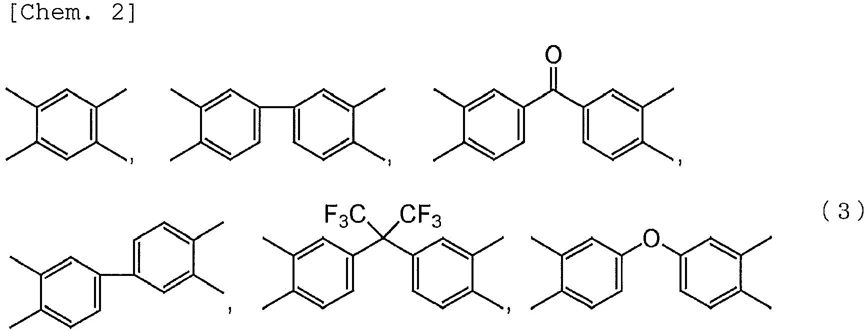

In formula (2), R² is a trivalent organic group having one or two benzene rings. R² is preferably any of the moieties represented by the following formulas (4). The polyamide-imide resin may have one of the moieties represented by formulas (4) as R², or may be a copolymer having at least two of these moieties as R²s.

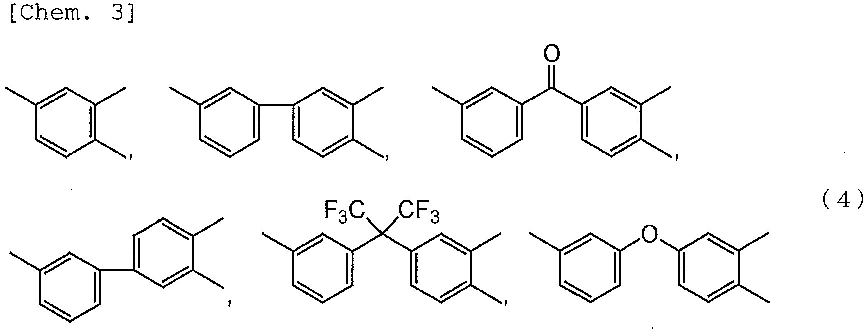

In formulas (1) and (2), R³ is a divalent organic group having one or two benzene rings. R³ is preferably any of the moieties represented by the following formulas (5). The polyimide resin and the polyamide-imide resin may have one of the moieties represented by formulas (5) as R³, or may be copolymers having at least two of these moieties as R³s.

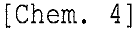

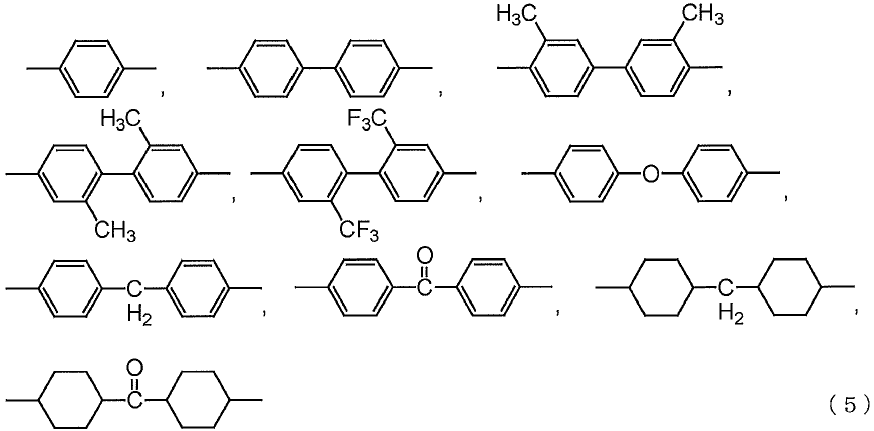

For inexpensiveness and excellent mechanical strength of supporting layers of the resulting water vapor barrier film, R¹, R², and R³ are preferably moieties represented by the following formulas (6). The polyimide resin may have a combination of one of the moieties represented by formulas (6) for R¹ and one of the moieties represented by formulas (6) for R³, or may be a copolymer having a combination of at least two of the moieties for R¹ and/or at least two of the moieties for R³. Likewise, the polyamide-imide resin may have a combination of one of the moieties represented by formulas (6) for R² and one of the moieties represented by formulas (6) for R³, or may be a copolymer having a combination of at least two of the moieties for R² and/or at least two of the moieties for R³.

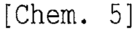

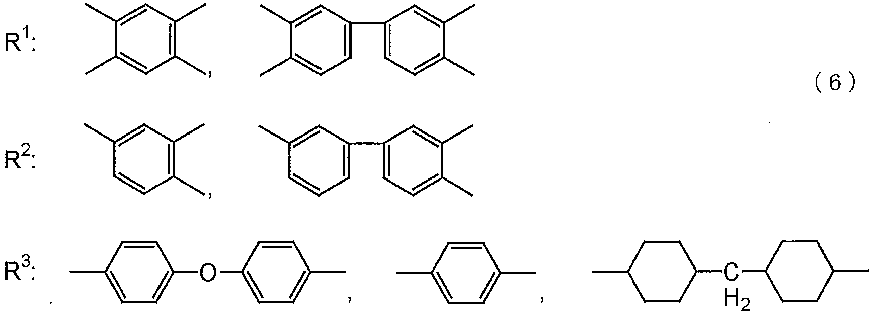

The water vapor barrier film of the present invention may contain a coupling agent, such as a silane coupling agent or a titanate coupling agent, to increase the mechanical strength.

Examples of the silane coupling agent include amino silane coupling agents, ureido silane coupling agents, vinyl silane coupling agents, methacrylic silane coupling agents, epoxy silane coupling agents, mercapto silane coupling agents, and isocyanate silane coupling agents.

Examples of the titanate coupling agent include titanate coupling agents having an alkylate group containing at least 1 to 60 carbon atoms, titanate coupling agents having an alkyl phosphite group, titanate coupling agents having an alkyl phosphate group, and titanate coupling agents having an alkyl pyrophosphate group.

The coupling agent may be mixed and reacted with the phyllosilicate mineral in advance, or may be mixed into the later-described dispersion for water vapor barrier films.

The preferable lower limit of the amount of the coupling agent used is 0.1% by weight, and the preferable upper limit is 3.0% by weight of the total weight of the phyllosilicate mineral. The use of the coupling agent in an amount of less than 0.1% by weight may not sufficiently produce the effect. The use of the coupling agent in an amount of more than 3.0% by weight may not produce an effect proportional to the amount. The more preferable lower limit of the amount of the coupling agent is 0.5% by weight, and the more preferable upper limit is 2.0% by weight.

The thickness of the water vapor barrier film of the present invention is preferably not less than 10 µm. If the thickness is less than 10 µm, the water vapor barrier film may have reduced water vapor barrier performance. Additionally, the film may have low mechanical strength, and therefore may be difficult to handle. The thickness of the water vapor barrier film is more preferably not less than 20 µm, still more preferably not less than 40 µm, further more preferably not less than 45 µm, and particularly preferably not less than 50 µm.

The thickness of the water vapor barrier film of the present invention is preferably not more than 250 µm. If the thickness of the water vapor barrier film is more than 250 µm, the film may be stiff and have low flexural strength. The thickness of the water vapor barrier film is more preferably not more than 200 µm.

The water vapor barrier film of the present invention has a water vapor permeability, measured at 40°C and 90%RH, of not more than 0.5 g/m²·day. If the water vapor permeability measured at 40°C and 90%RH is more than 0.5 g/m²·day, the film is not easily used as, for example, an electric material. The water vapor permeability measured at 40°C and 90%RH is preferably not more than 0.2 g/m²·day, and more preferably not more than 0.1 g/m²·day.

The water vapor barrier film of the present invention preferably has a flammability of VTM-0 as determined by the UL-94 thin material vertical burning test (VTM test). The VTM test is performed by rolling a film specimen into a cylinder, mounting the rolled specimen vertically to the clamp, bringing 20-mm size flame into contact with the specimen for 3 seconds twice, and determining the flammability of the specimen from its burning behaviors based on the criteria shown in Table 1.

For evaluation by the UL-94 VTM test, the water vapor barrier film of the present invention preferably has a thickness of 200 µm or less, and more preferably 150 µm or less.

**[Table 1]**

| | | Flammability | | |
|---|---|---|---|---|
| | | VTM-O | VTM-1 | VTM-2 |
| Determination criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by droppings | Not occurred | Not occurred | Occurred |

The water vapor barrier film of the present invention preferably has a flammability of V-0 as determined by the UL-94 vertical burning test (V test). The V test is performed by mounting a specimen vertically to the clamp, bringing 20-mm size flame into contact with the specimen for 10 seconds twice, and determining the flammability of the specimen from its burning behaviors based on the criteria shown in Table 2.

**[Table 2]**

| | | Flammability | | |
|---|---|---|---|---|
| | | V-0 | V-1 | V-2 |
| Determination criteria | Burning time of each specimen | ≤ 10 sec | ≤ 30 sec | ≤ 30 sec |
| | Total burning time of 5 specimens | ≤ 50 sec | ≤ 250 sec | ≤ 250 sec |
| | Burning + glowing time of each specimen | ≤ 30 sec | ≤ 60 sec | ≤ 60 sec |
| | Burning to clamp | Not occurred | Not occurred | Not occurred |
| | Cotton ignition by droppings | Not occurred | Not occurred | Occurred |

Additionally, the water vapor barrier film preferably has a flammability of 5V-A or 5V-B as determined by the UL-94 125-mm vertical burning test (5V test). In the 5V test, a strip specimen is vertically mounted to the clamp, 125-mm size flame is brought into contact with the specimen for 5 seconds five times, and the flammability of the specimen is determined from its burning behaviors. Also in the test, a sheet specimen is horizontally held, 125-mm size flame is brought into contact with the specimen from the bottom for 5 seconds five times, and the flammability of the specimen is determined from its burning behaviors based on the criteria shown in Table 3.

**[Table 3]**

| | | Flammability | |
|---|---|---|---|
| | | 5V-A | 5V-B |
| Determination criteria | Burning + glowing time of each strip specimen after the 5th flame contact | ≤ 30 sec | ≤ 60 sec |
| | Cotton ignition by droppings from strip specimen | Not occurred | Not occurred |
| | Presence of hole after flame contact (sheet specimen) | No | Yes |

The water vapor barrier film of the present invention preferably has "non-combustibility" defined in a rolling stock material combustion test based on "Ministerial Ordinance to Provide the Technical Standard on Railway", the Ministerial Ordinance No. 151 promulgated by the Ministry of Land, Infrastructure, Transport and Tourism.

Preferably, the water vapor barrier film of the present invention, when evaluated by a heat release test using a cone calorimeter in accordance with ISO 5660-1, has a total heat release per unit sample area by 20-minute heating of 8 MJ/m² or less, a maximum heat release rate per unit sample area during 20-minute heating of 300 kW/m² or less, and a time from the start of the test to the ignition of 60 seconds or more.

The water vapor barrier film of the present invention preferably has a tear strength of 25 N/mm or more. If the tear strength is lower than 25 N/mm, the film may be easily torn, and therefore is difficult to handle. The film more preferably has a tear strength of 30 N/mm or more, and still more preferably of 40 N/mm or more.

The tear strength herein refers to a value obtained by the measuring method in accordance with JIS K 7128-1.

The water vapor barrier film of the present invention preferably has a tensile strength of 25 N/mm² or more. If the tensile strength is lower than 25 N/mm², the film may be easily torn, and therefore is difficult to handle. The film more preferably has a tensile strength of 30 N/mm² or more, and still more preferably of 40 N/mm² or more.

The tensile strength herein refers to a value obtained by the measuring method in accordance with JIS K 7127-1, and is measured using a tensile strength tester with a grip distance of 80 mm and a pulling rate of 20 mm/min.

Preferably, the water vapor barrier film of the present invention, when evaluated by a flex resistance test using a cylindrical mandrel in accordance with JIS K 5600-5-1 (1999), cracks with a mandrel having a diameter of 20 mm or less. A film which cracks with a mandrel having a diameter of greater than 20 mm may have poor flexibility. The film preferably cracks with a mandrel having a diameter of 15 mm or less, more preferably of 12 mm or less, and particularly preferably of 10 mm or less.

The water vapor barrier film of the present invention preferably has a dielectric breakdown voltage of 20 kV/mm or more. If the dielectric breakdown voltage is lower than 20 kV/mm, the film may not be easily used as, for example, an electric material. The film more preferably has a dielectric breakdown voltage of 25 kV/mm or more, and still more preferably 30 kV/mm or more.

The water vapor barrier film of the present invention preferably has a partial discharge voltage of 700 V or more, as measured by the partial discharge test in accordance with IEC61730-2:2004, item 11.1. If the partial discharge voltage is 700 V or less, the film may be locally degraded because of electrolysis concentration, and thus is not easily used as an electric material. The film preferably has a partial discharge voltage of 1000 V or more, more preferably 1500 V or more, and still more preferably 2000 V or more.

The water vapor barrier film of the present invention preferably has a coefficient of water absorption of 2.0% by weight or less, as measured after being immersed in 40°C water for 24 hours. If the coefficient of water absorption is higher than 2.0% by weight, the film may not be easily used as, for example, an electric material. The film more preferably has a coefficient of water absorption of 1.0% by weight.

The water vapor barrier film of the present invention preferably has a coefficient of moisture absorption of 2.0% by weight or less, as measured after being left to stand for 24 hours at 40°C and 90%RH. If the coefficient of moisture absorption is higher than 2.0% by weight, the film may not be easily used as, for example, an electric material. The film more preferably has a coefficient of moisture absorption of 1.0% by weight or less.

The water vapor barrier film of the present invention preferably does not undergo a change such as discoloration or peeling on the surface or the cross section even after storage for at least 500 hours in a weather resistance test in an environment at 85°C and 85%RH. A film which undergoes a change within 500 hours in the weather resistance test may not be used for outdoor products such as solar cells. The film preferably does not undergo a change such as discoloration or peeling on the surface or the cross-section in the weather resistance test even after more preferably 1000 hours or more, still more preferably 2000 hours or more, and particularly preferably 3000 hours or more.

Another aspect of the present invention is a dispersion for water vapor barrier films which is intended to be used to produce the water vapor barrier film of the present invention. The dispersion contains a dispersion medium; and a nonvolatile component including a phyllosilicate mineral and at least one of a synthetic resin and a synthetic resin precursor, and the phyllosilicate mineral is present in an amount of not less than 30% by weight and not more than 90% by weight of the total weight of the nonvolatile component, the phyllosilicate mineral comprises a non-swelling clay mineral and a swelling clay mineral, the non-swelling clay mineral has a swelling force of less than 5 mL/2 g and the swelling clay mineral has a swelling force of not less than 5 mL/2 g, the swelling force being measured according to the measurement method as set out in the description, the swelling clay mineral is present in an amount of not less than 2% by weight and not more than 80% by weight of the total weight of the phyllosilicate mineral.

The water vapor barrier film of the present invention can be produced by a method including: step 1 of preparing a swelling clay mineral dispersion containing a dispersion medium and a swelling clay mineral; step 2 of preparing a non-swelling clay mineral dispersion containing a dispersion medium, a non-swelling clay mineral, and at least one of a synthetic resin and a synthetic resin precursor; step 3 of mixing the swelling clay mineral dispersion and the non-swelling clay mineral dispersion, thereby providing the dispersion for water vapor barrier films of the present invention; step 4 of spreading the obtained dispersion for water vapor barrier films on a substrate, and leaving it standing; and step 5 of forming a film by removing the dispersion medium from the dispersion for water vapor barrier films spread on the substrate; wherein the non-swelling clay mineral has a swelling force of less than 5 mL/2 g and the swelling clay mineral has a swelling force of not less than 5 mL/2 g, the swelling force being measured according to the measurement method as set out in the description. This method for producing a water vapor barrier film is also one aspect of the present invention.

The method for preparing a dispersion for water vapor barrier films of the present invention, which includes the step of mixing a swelling clay mineral dispersion and a non-swelling clay mineral dispersion, enables production of a water vapor barrier film having high mechanical strength, good flexibility, good flame retardancy, and good water vapor barrier performance, which has been difficult by conventional techniques.

The method for producing a water vapor barrier film of the present invention includes step 1 of preparing a swelling clay mineral dispersion containing a dispersion medium and a swelling clay mineral.

In step 1 of preparing a swelling clay mineral dispersion, the swelling clay mineral is preferably modified with a silylating agent and subjected to substitution of interlayer cations before mixing the swelling clay mineral and the dispersion medium.

The swelling clay mineral can be reacted with the silylating agent, for example, by mixing the swelling clay mineral and the silylating agent by a ball mill treatment or using a planetary centrifugal mixer.

The substitution of interlayer cations of the swelling clay mineral can be accomplished by, for example, mixing and dispersing the swelling clay mineral in an aqueous solution containing a cation for substitution by shaking, stirring them with a stirrer, or mixing and dispersing them with a planetary centrifugal mixer.

In step 1 of preparing a swelling clay mineral dispersion, the swelling clay mineral is mixed with the dispersion medium to gel, and the dispersion medium is further added to the gel, thereby providing a swelling clay mineral dispersion. If the gel is used in the following steps without making it into a swelling clay mineral dispersion in step 1, the resulting dispersion for water vapor barrier films will contain aggregates, and cannot provide a homogenous water vapor barrier film.

The preferable lower limit of the amount of the swelling clay mineral in the swelling clay mineral dispersion prepared in step 1 is 1% by weight of the total weight of the swelling clay mineral dispersion, and the preferable upper limit is 20% by weight. If the amount of the swelling clay mineral is less than 1% by weight, the dispersion contains too much dispersion medium, and removal of the dispersion medium may take a long time. If the amount of the swelling clay mineral is more than 20% by weight, the dispersion for water vapor barrier films may be too viscous to be used to form films. The more preferable lower limit of the amount of the swelling clay mineral is 1.5% by weight, and the more preferable upper limit is 15% by weight.

Examples of the dispersion medium in the swelling clay mineral dispersion include hydrocarbon solvents (e.g., n-pentane, n-hexane, n-octane, n-decane), alcohol solvents (e.g., methanol, ethanol, 1-propanol, 2-propanol, 1-butanol, 2-butanol, isobutanol, tert-butanol, 1-pentanol, 2-pentanol, 1-hexanol, 2-hexanol, ethylene glycol, propylene glycol), ketone solvents (e.g., acetone, methyl ethyl ketone, diethyl ketone, methyl isobutyl ketone, cyclohexanone), amide solvents (e.g., N,N-dimethylformamide, N,N-dimethylacetamide, N,N-dimethylpropionamide, N-methyl-2-pyrrolidone), ether solvents (e.g., diethylether, methyl-tert-butyl ether, dioxane, tetrahydrofuran, cyclopentyl methyl ether), benzene solvents (e.g., benzene, chlorobenzene, o-dichlorobenzene, m-dichlorobenzene, p-dichlorobenzene, toluene, o-xylene, p-xylene, ethylbenzene, phenol, p-chlorophenol, o-chlorophenol, o-cresol), sulfur solvents (e.g., dimethyl sulfoxide, dimethyl sulfone, sulfolane), and water. For high solubility of the synthetic resin, at least one selected from the group consisting of N-methyl-2-pyrrolidone, N,N-dimethylformamide, N,N-dimethylacetamide, dimethyl sulfoxide, tetrahydrofuran, sulfolane, and water is preferable. Any of these dispersion media may be used alone, or two or more of these may be used in combination.

The method for producing a water vapor barrier film of the present invention includes step 2 of preparing a non-swelling clay mineral dispersion containing a dispersion medium, a non-swelling clay mineral, and at least one of a synthetic resin and a synthetic resin precursor.

The preferable lower limit of the amount of the nonvolatile component in the non-swelling clay mineral dispersion prepared in step 2 is 18% by weight of the total weight of the non-swelling clay mineral dispersion, and the preferable upper limit is 65% by weight. If the amount of the nonvolatile component is less than 18% by weight, the dispersion for water vapor barrier films may not be homogeneous, and may not provide a homogeneous film. If the amount of the nonvolatile component is more than 65% by weight, the dispersion for water vapor barrier films may be too viscous to be used to form films. The more preferable lower limit of the amount of the nonvolatile component is 20% by weight, and the more preferable upper limit is 55% by weight.

The term "nonvolatile component" herein refers to a component that does not have a boiling point or has a boiling point of 300°C or higher at normal pressure. The proportion of the nonvolatile component can be determined from the weight of a solid residue resulting from removal of the dispersion medium through vacuum evaporation using a device such as a thermogravimetric analyzer (TG), a thermogravimetric/differential thermal analyzer (TG-DTA), or an evaporator.

The swelling clay mineral and the non-swelling clay mineral in the dispersion for water vapor barrier films of the present invention are the same as those in the water vapor barrier film of the present invention, and the description thereof is omitted.

Examples of the synthetic resin in the dispersion for water vapor barrier films of the present invention include those mentioned above for the water vapor barrier film of the present invention.

Examples of the synthetic resin precursor include polyamide acids. Imidization of a polyamide acid gives a polyimide resin or a polyamide-imide resin.

The imidization of a polyamide acid can be accomplished by, for example, ring-closing a polyamide acid by heating, or chemically ring-closing a polyamide acid.

The ring-closing imidization of a polyamide acid by heating is not particularly limited, and can be accomplished by, for example, dispersing the polyamide acid in a dispersion medium, and heating the dispersion at 120 to 400°C for 0.5 to 24 hours.

The same dispersion media as those mentioned for the dispersion medium in the swelling clay mineral dispersion can be used as the dispersion medium in the non-swelling clay mineral dispersion.

The method for producing a water vapor barrier film of the present invention includes step 3 of mixing the swelling clay mineral dispersion and the non-swelling clay mineral dispersion, thereby preparing the dispersion for water vapor barrier films of present invention.

The lower limit of the amount of the phyllosilicate mineral in the dispersion for water vapor barrier films of the present invention is 30% by weight of the total weight of the nonvolatile component, and the upper limit is 90% by weight. If the amount of the phyllosilicate mineral is less than 30% by weight, the resulting film has high water vapor permeability. If the amount of the phyllosilicate mineral is more than 90% by weight, the resulting film has poor mechanical strength. The preferable lower limit of the amount of the phyllosilicate mineral is 35% by weight, and the preferable upper limit is 85% by weight. The more preferable lower limit is 40% by weight, and the more preferable upper limit is 80% by weight. The still more preferable lower limit is 50% by weight, and the still more preferable upper limit is 70% by weight. The lower limit is particularly preferably 60% by weight.

Examples of the method of spreading the dispersion on a substrate in step 4 include a method of applying the dispersion into the shape of a film using, for example, a doctor blade or a bar coater.

In step 4, the dispersion is preferably spread to a thickness of 100 µm or more on the substrate. A dispersion deposit with a thickness of less than 100 µm may result in a thin water vapor barrier film with low mechanical strength. The lower limit of the thickness of the dispersion is more preferably 150 µm, and still more preferably 200 µm.

The substrate on which the dispersion is to be spread is preferably made of glass, polyethylene terephthalate, polyimide, polyethylene, or polypropylene, in terms of the compatibility between the substrate and the dispersion, wettability, and release property after drying.

Examples of the method for removing the dispersion medium from the dispersion for water vapor barrier films spread on the substrate in step 5 include various solid liquid separation methods such as centrifugation, filtration, vacuum drying, freeze vacuum drying, heat evaporation, and combinations of these methods. In the case of employing, for example, heat evaporation in which the dispersion is poured into a vessel, a film is obtained by drying the dispersion applied to the substrate in a horizontal position in a forced air oven at 20°C to 150°C, preferably at 30°C to 120°C, for about 0.5 to 24 hours, preferably 2 to 12 hours.

The removal of the dispersion medium in step 5 is preferably performed at 150°C or lower in order to avoid defects on the resulting film.

In the case where the dispersion for water vapor barrier films of the present invention contains the synthetic resin precursor, the resulting film is further heated in an electric furnace or the like into a water vapor barrier film. Specifically, in the case where a polyamide acid is used as the synthetic resin precursor, for example, a film obtained in the manner described above is further heated at 120 to 400°C for 0.5 to 24 hours into a water vapor barrier film.

The water vapor barrier film of the present invention can be used as a solar cell back sheet because of its flexibility, moisture resistance, and high mechanical strength. Such a solar cell back sheet is also another aspect of the present invention.

A solar cell incorporating the water vapor barrier film of the present invention or the solar cell back sheet of the present invention is also another aspect of the present invention. The solar cell of the present invention has good durability and good weather resistance which are attributed to the flexibility, moisture resistance, and high mechanical strength of the water vapor barrier film of the present invention and the solar cell back sheet of the present invention. General solar cell back sheets have a multi-layer structure including multiple resin layers. A problem of such a structure is that adhesive layers bonding resin layers degrade after long-term use. By contrast, the water vapor barrier film of the present invention, which is composed of a single layer or an integrated laminate of two or more layers, can be used as a solar cell back sheet to prevent degradation of solar cells over time.

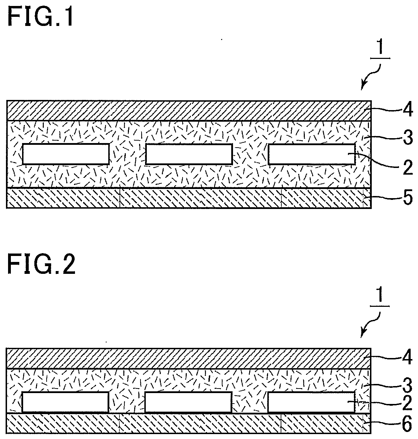

Fig. 1 is a schematic cross-sectional view illustrating an example of the solar cell of the present invention.

As illustrated in Fig. 1, a solar cell 1 of the present invention includes solar cell devices 2 for converting light energy into electric energy by the photovoltaic effect. The solar cell devices 2 are enclosed by a sealing material 3. The solar cell 1 of the present invention has a light-transmissive substrate 4, which constitutes the surface on the sunlight receiving side, and has a solar cell back sheet 5 of the present invention, which constitutes the surface on the opposite side to the light-transmissive substrate 4.

Fig. 2 is a schematic cross-sectional view illustrating another example of the solar cell of the present invention.

In Fig. 2, a solar cell 1 of the present invention includes solar cell devices 2 enclosed by a sealing material 3 similarly to that illustrated in Fig. 1. The solar cell 1 of the present invention includes a light-transmissive substrate 4, which constitutes the surface on the sunlight receiving side, and a water vapor barrier film 6 of the present invention, which constitutes the surface on the opposite side to the light-transmissive substrate 4.

The solar cell devices 2 may be formed from any materials that can convert light energy into electric energy by photovoltaic effect. For example, monocrystalline silicon, polycrystalline silicon, amorphous silicon, and compound semiconductors (group III-V, group II-VI, and other compounds) can be used. Preferred among these are polycrystalline silicon, amorphous silicon, and CIGS (copper indium gallium selenide).

Examples of the sealing material 3 include ethylene-vinyl acetate copolymers, ethylene-aliphatic unsaturated carboxylic acid copolymers, ethylene-aliphatic carboxylic acid ester copolymers, and saponified products of these copolymers.

Since the light-transmissive substrate 4 constitutes the outermost layer on the sunlight receiving side of the solar cell 1, the light-transmissive substrate 4 preferably has excellent properties including weather resistance, water repellence, contamination resistance, and mechanical strength in addition to transparency.

Examples of the light-transmissive substrate 4 include substrates made of a resin (e.g., polyester resin, fluororesin, acrylic resin, ethylene-vinyl acetate copolymer) and glass substrates. Glass substrates are preferred because they have excellent weather resistance and excellent impact resistance, and can be produced at a low cost. Particularly in terms of the excellent weather resistance, fluororesin is also suitable.

The solar cell 1 of the present invention can be produced by any methods without limitation, and specifically can be produced by, for example, stacking the light-transmissive substrate 4, the sealing material 3 enclosing the solar cell devices 2, and the solar cell back sheet 5 of the present invention in the stated order, and vacuum-laminating these components; or stacking the light-transmissive substrate 4, the sealing material 3, and the solar cell devices 2 formed on the water vapor barrier film 6 of the present invention in the stated order, and vacuum-laminating these components.

### - Advantageous Effects of Invention

The present invention provides a water vapor barrier film having good flexibility, good moisture resistance, and high mechanical strength. The present invention also provides a dispersion for water vapor barrier films which is intended to be used to produce the water vapor barrier film, a method for producing the water vapor barrier film, a solar cell back sheet incorporating the water vapor barrier film, and a solar cell incorporating the water vapor barrier film or the solar cell back sheet.

### BRIEF DESCRIPTION OF DRAWINGS

[Fig. 1] Fig. 1 is a schematic cross-sectional view illustrating an example of the solar cell of the present invention.
[Fig. 2] Fig. 2 is a schematic cross-sectional view illustrating another example of the solar cell of the present invention.
[Fig. 3] Figs. 3 show electron microscopic photographs of cross sections of films produced in Examples 1 to 4 and Comparative Example 1.

### DESCRIPTION OF EMBODIMENTS

The following examples are offered to illustrate the present invention in further detail, and are not to be construed as limiting the scope thereof.

### (Example 1)

### (Production of lithium-substituted modified clay)

Kunipia F (KUNIMINE INDUSTRIES CO., LTD.) which is purified natural bentonite mainly composed of montmorillonite (layer charge per 1/2 unit cell: 0.2 to 0.6, average particle size: 1.1 µm) was sufficiently dried in an oven at a temperature of 110°C or higher. A 300 g portion of the bentonite was introduced with alumina balls into a ball mill pot. Subsequently, 6 g of a silylating agent (Chisso Corporation, "Sila-Ace S330") was added to the pot, the pot was purged with nitrogen gas, and a ball mill treatment was performed for 1 hour. Thus, a modified clay was prepared.

A 24 g portion of the obtained modified clay was added to 400 mL of a 0.5 N lithium nitrate aqueous solution, and mixed and dispersed therein by shaking. By 2-hour shaking dispersion, the interlayer ions of the clay were substituted by lithium ion. Thus, a dispersion was obtained.

Then, the obtained dispersion was separated into solid and liquid phases by centrifugation, and the obtained solids were washed with a mixture solution containing 280 g of distilled water and 120 g of ethanol to remove excess salt. This washing procedure was performed twice or more. The obtained product was sufficiently dried in an oven, and cracked. In this manner, a lithium-substituted modified clay (layer charge per 1/2 unit cell: 0.2 to 0.6) was obtained.

### (Evaluation of swelling property of lithium-substituted modified clay)

A 2.0 g portion of the obtained lithium-substituted modified clay powder was added by portions in 100 mL of water in a 100-mL measuring cylinder to sediment spontaneously. After one-hour standing from the completion of addition, the apparent volume of the swelling clay mineral was read, and the swelling force was found to be 85 mL/2 g.

### (Preparation of swelling clay mineral gel)

A 10 g portion of the obtained lithium-substituted modified clay was taken and added into a container. To this was added 20 mL of pure water, and the mixture was left standing for about 10 minutes to allow the lithium-substituted modified clay to be soaked with pure water. Subsequently, the mixture was briefly mixed with a stainless steel spatula, and then with a planetary centrifugal mixer ("ARE-310" from THINKY) in a mixing mode (2000 rpm) for 10 minutes. To the mixture was added 20 mL of pure water again, and the mixture was mixed in such a manner to allow pure water uniformly mixed until the mixture was integrated.

Then, the mixture was mixed with the planetary centrifugal mixer in the mixing mode (2000 rpm) for 10 minutes. The mixture became a clay pregel with better cohesiveness than that of the mixture after the first mixing treatment. To the mixture was added 50 mL of pure water, and the mixture was sufficiently kneaded with a stainless steel spatula. Large aggregates (masses of the gel) were crushed as many as possible, and then the mixture was mixed again with the planetary centrifugal mixer in the mixing mode (2000 rpm) for 10 minutes. In this manner, a swelling clay mineral gel was obtained.

### (Preparation of swelling clay mineral dispersion)

In a container, 350 g of N-methyl-2-pyrrolidone was charged, and then a 10 g portion of the swelling clay mineral gel was further added thereto under stirring with a homogenizer ("ULUTRA TURRAX T50" from IKA). The stirring was continued at about 7000 rpm for about 30 minutes. In this manner, a swelling clay mineral dispersion was obtained.

### (Preparation of non-swelling clay mineral dispersion)

In a plastic airtight container, 4.4 g of talc ("Talc MS-K" from Nippon Talc Co., Ltd., layer charge: 0, average particle size: 14 µm) and 33.0 g of a 18.6% by weight solution of a polyamide acid in N-methyl-2-pyrrolidone ("U-Varnish A" from Ube Industries, Ltd.) were charged, and stirred with the planetary centrifugal mixer ("ARE-310" from THINKY) in the mixing mode (2000 rpm) for 10 minutes. Thus, a homogenous non-swelling clay mineral dispersion was prepared. The talc content of the dispersion was 41.9% by weight of the total of the nonvolatile component, and the nonvolatile component content was 28.1% by weight of the total weight of the dispersion.

The polyamide acid contained in "U-varnish A" is an aromatic polyamide acid having repeating units represented by the following formula (7).

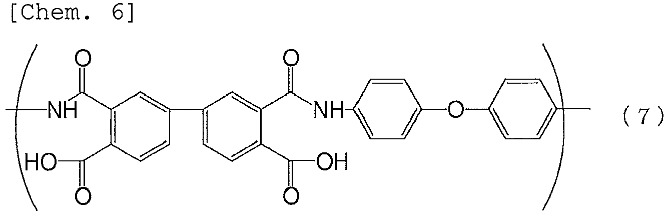

### (Evaluation of swelling property of talc)

To 100 mL of water in a 100-mL measuring cylinder, 2.0 g of the talc powder ("Talc MS-K" from Nippon Talc Co., Ltd.) which was the same as that used in the process "Preparation of non-swelling clay mineral dispersion" was added by portions to sediment spontaneously. After one-hour standing from the completion of addition, the apparent volume of the swelling clay mineral was read, and the swelling force was found to be 2 mL/2 g.

### (Preparation of dispersion for water vapor barrier films)

A 49.5 g portion of the swelling clay mineral dispersion and a 37.4 g portion of the non-swelling clay mineral dispersion were charged in a plastic airtight container, and stirred with the planetary centrifugal mixer ("ARE-310" from THINKY) in the mixing mode (2000 rpm) for 10 minutes, and then in a deaeration mode (2200 rpm) for 10 minutes. In this manner, a homogeneous dispersion for water vapor barrier films was prepared. The phyllosilicate mineral content of the dispersion was 47.4% by weight of the total of the nonvolatile component, and the swelling clay mineral content was 20.0% by weight of the total weight of the phyllosilicate mineral.

### (Formation of film)

The obtained dispersion for water vapor barrier films was applied with a doctor blade to a polypropylene sheet having a smooth, rectangular bottom face, to a thickness of 2000 µm. The dispersion was dried in a forced air oven at 50°C for 10 hours with the polypropylene sheet held in a horizontal position, so that a film was formed on the polypropylene sheet. The film was peeled off the polypropylene sheet, and heated at 120°C for 1 hour, at 150°C for 1 hour, at 200°C for 1 hour, and then at 350°C for 12 hours. In this manner, a 90 µm thick water vapor barrier film made of talc, montmorillonite, and a polyimide resin was obtained. The phyllosilicate mineral content of the film was 47.4% by weight of the total weight, and the swelling clay mineral content was 20.0% by weight of the total weight of the phyllosilicate mineral.

### (Example 2)

A homogeneous dispersion for water vapor barrier films was prepared in the same manner as in Example 1, except that a 99.0 g portion of the swelling clay mineral dispersion and a 37.4 g portion of the non-swelling clay mineral dispersion, both of which were prepared in Example 1, were used in the process "Preparation of dispersion for water vapor barrier films". The phyllosilicate mineral content of the dispersion was 52.0% by weight of the total of the nonvolatile component, and the swelling clay mineral content was 33.3% by weight of the total weight of the phyllosilicate mineral.

A 110 µm thick water vapor barrier film made of talc, montmorillonite, and a polyimide resin was obtained in the same manner as in the process "Formation of film" in Example 1. The phyllosilicate mineral content of the film was 52.0% by weight of the total weight, and the swelling clay mineral content was 33.3% by weight of the total weight of the phyllosilicate mineral.

### (Example 3)

A homogeneous dispersion for water vapor barrier films was prepared in the same manner as in Example 1, except that a 148.5 g portion of the swelling clay mineral dispersion and a 37.4 g portion of the non-swelling clay mineral dispersion, both of which were prepared in Example 1, were used in the process "Preparation of dispersion for water vapor barrier films". The phyllosilicate mineral content of the dispersion was 55.8% by weight of the total of the nonvolatile component, and the swelling clay mineral content was 42.9% by weight of the total weight of the phyllosilicate mineral.

A 90 µm thick water vapor barrier film made of talc, montmorillonite, and a polyimide resin was obtained in the same manner as in the process "Formation of film" in Example 1. The phyllosilicate mineral content of the film was 55.8% by weight of the total of the nonvolatile component, and the swelling clay mineral content was 42.9% by weight of the total weight of the phyllosilicate mineral.

### (Example 4)

A homogeneous dispersion for water vapor barrier films was prepared in the same manner as in Example 1, except that a 198.0 g portion of the swelling clay mineral dispersion and a 37.4 g portion of the non-swelling clay mineral dispersion, both of which were prepared in Example 1, were used in the process "Preparation of dispersion for water vapor barrier films". The phyllosilicate mineral content of the dispersion was 59.1% by weight of the total of the nonvolatile component, and the swelling clay mineral content was 50.0% by weight of the total weight of the phyllosilicate mineral.

A 70 µm thick water vapor barrier film made of talc, montmorillonite, and a polyimide resin was obtained in the same manner as in the process "Formation of film" in Example 1. The phyllosilicate mineral content of the film was 59.1% by weight of the total of the nonvolatile component, and the swelling clay mineral content was 50.0% by weight of the total weight of the phyllosilicate mineral.

### (Example 5)

### (Preparation of non-swelling clay mineral dispersion)

In a plastic airtight container, 2.2 g of talc ("Talc MS-K" from Nippon Talc Co., Ltd.) and 47.8 g of the 18.6% by weight solution of a polyamide acid in N-methyl-2-pyrrolidone ("U-Varnish A" from Ube Industries, Ltd.) were charged, and stirred with the planetary centrifugal mixer ("ARE-310" from THINKY) in the mixing mode (2000 rpm) for 10 minutes. Thus, a homogenous non-swelling clay mineral dispersion was prepared. The talc content of the dispersion was 19.8% by weight of the total of the nonvolatile component, and the nonvolatile component content was 22.2% by weight of the total weight of the dispersion.

### (Preparation of dispersion for water vapor barrier films)

A homogeneous dispersion for water vapor barrier films was prepared in the same manner as in Example 1, except that a 50.0 g portion of the non-swelling clay mineral dispersion prepared above and a 99.0 g portion of the swelling clay mineral dispersion prepared in the process "Preparation of dispersion for water vapor barrier films" in Example 1 were used. The phyllosilicate mineral content of the dispersion was 33.1% by weight of the total of the nonvolatile component, and the swelling clay mineral content was 50.0% by weight of the total weight of the phyllosilicate mineral.

### (Formation of film)

An 85 µm thick water vapor barrier film made of talc, montmorillonite, and a polyimide resin was obtained in the same manner as in the process "Formation of film" in Example 1, except that the dispersion was applied to a thickness of 1500 µm with a doctor blade. The phyllosilicate mineral content of the film was 33.1% by weight of the total weight, and the swelling clay mineral content was 50.0% by weight of the total weight of the phyllosilicate mineral.

### (Example 6)

### (Production of lithium-substituted clay)

Kunipia F (KUNIMINE INDUSTRIES CO., LTD.) which is purified natural bentonite mainly composed of montmorillonite (layer charge per 1/2 unit cell: 0.2 to 0.6, average particle size: 1.1 µm) was sufficiently dried in an oven at a temperature of 110°C or higher. A 24 g portion of the dried clay was added to 400 mL of a 0.5 N lithium nitrate aqueous solution, and mixed and dispersed by shaking. By 2-hour shaking dispersion, the interlayer ions of the clay were substituted by lithium ion. Thus, a dispersion was obtained.

Then, the obtained dispersion was separated into solid and liquid phases by centrifugation, and the obtained solids were washed with a mixture solution containing 280 g of distilled water and 120 g of ethanol to remove excess salt. This washing procedure was performed twice or more. The obtained product was sufficiently dried in an oven, and cracked. In this manner, a lithium-substituted modified clay (layer charge per 1/2 unit cell: 0.2 to 0.6) was obtained.

### (Evaluation of swelling property of lithium-substituted clay)

A 2.0 g portion of the obtained lithium-substituted clay powder was added by portions in 100 mL of water in a 100-mL measuring cylinder to sediment spontaneously. After one-hour standing from the completion of addition, the apparent volume of the swelling clay mineral was read, and the swelling force was found to be 90 mL/2 g.

### (Preparation of swelling clay mineral gel)

A 20 g portion of the obtained lithium-substituted clay was taken and added into a container. To this was added 40 mL of pure water, and the mixture was left standing for about 10 minutes to allow the lithium-substituted modified clay to be soaked with pure water. Subsequently, the mixture was briefly mixed with a stainless steel spatula, and then with the planetary centrifugal mixer ("ARE-310" from THINKY) in the mixing mode (2000 rpm) for 10 minutes. To the mixture was added 40 mL of pure water again, and the mixture was mixed in such a manner to allow pure water uniformly mixed until the mixture was integrated.

The mixture was then mixed with the planetary centrifugal mixer in the mixing mode (2000 rpm) for 10 minutes. In this manner, a swelling clay mineral gel was obtained.

### (Preparation of swelling clay mineral dispersion)

In a container, 350 g of N-methyl-2-pyrrolidone was charged, and then a 100 g portion of the swelling clay mineral gel was further added thereto under stirring with the homogenizer ("ULUTRA TURRAX T50" from IKA). The stirring was continued at about 7000 rpm for about 30 minutes. In this manner, a swelling clay mineral dispersion was obtained.

### (Preparation of non-swelling clay mineral dispersion)

In a plastic airtight container, 4.0 g of talc ("Talc MS-K" from Nippon Talc Co., Ltd.) and 33.0 g of the 18.6% by weight solution of a polyamide acid in N-methyl-2-pyrrolidone ("U-Varnish A" from Ube Industries, Ltd.) were charged, and stirred with the planetary centrifugal mixer ("ARE-310" from THINKY) in the mixing mode (2000 rpm) for 10 minutes. In this manner, a homogenous non-swelling clay mineral dispersion was prepared. The talc content of the dispersion was 39.6% by weight of the total of the nonvolatile component, and the nonvolatile component content was 27.3% by weight of the total weight of the dispersion.

### (Preparation of dispersion for water vapor barrier films)

A 68.0 g portion of the swelling clay mineral dispersion and a 37.0 g portion of the non-swelling clay mineral dispersion were charged in a plastic airtight container, and stirred with the planetary centrifugal mixer ("ARE-310" from THINKY) in the mixing mode (2000 rpm) for 10 minutes, and then in the deaeration mode (2200 rpm) for 10 minutes. In this manner, a homogeneous dispersion for water vapor barrier films was prepared. The phyllosilicate mineral content of the dispersion was 53.4% by weight of the total of the nonvolatile component, and the swelling clay mineral content was 42.9% by weight of the total weight of the phyllosilicate mineral.

### (Formation of film)

The obtained dispersion for water vapor barrier films was applied with a doctor blade to a polypropylene sheet having a smooth, rectangular bottom face, to a thickness of 1500 µm. The dispersion was dried in a forced air oven at 50°C for 10 hours with the polypropylene sheet held in a horizontal position, so that a film was formed on the polypropylene sheet. The film was peeled off the polypropylene sheet, and heated at 120°C for 1 hour, at 150°C for 1 hour, at 200°C for 2 hours, and then at 350°C for 12 hours. In this manner, an 80 µm thick water vapor barrier film made of talc, montmorillonite, and a polyimide resin was obtained. The phyllosilicate mineral content of the film was 53.4% by weight of the total weight, and the swelling clay mineral content was 42.9% by weight of the total weight of the phyllosilicate mineral.

### (Example 7)

### (Preparation of dispersion for water vapor barrier films)

A homogeneous dispersion for water vapor barrier films was prepared in the same manner as in Example 6, except that a 114.0 g portion of the swelling clay mineral dispersion and a 37.0 g portion of the non-swelling clay mineral dispersion, both of which were prepared in the process "Preparation of dispersion for water vapor barrier films" in Example 6, were used. The phyllosilicate mineral content of the dispersion was 59.9% by weight of the total of the nonvolatile component, and the swelling clay mineral content was 56.0% by weight of the total weight of the phyllosilicate mineral.

### (Formation of film)

A 100 µm thick water vapor barrier film made of talc, montmorillonite, and a polyimide resin was formed in the same manner as in the process "Formation of film" in Example 6, except that the dispersion for water vapor barrier films obtained above was used. The phyllosilicate mineral content of the film was 59.9% by weight of the total weight, and the swelling clay mineral content was 56.0% by weight of the total weight of the phyllosilicate mineral.

### (Example 8)

### (Preparation of non-swelling clay mineral dispersion)

A homogeneous non-swelling clay mineral dispersion was prepared in the same manner as in Example 6, except that talc ("Talc GAT-40" from Nippon Talc Co., Ltd., average particle size: 7.1 µm) was used instead of talc "Talc MS-K" from Nippon Talc Co., Ltd.) in the process "Preparation of non-swelling clay mineral dispersion" in Example 6. The talc content of the dispersion was 39.6% by weight of the total of the nonvolatile component, and the nonvolatile component content was 27.3% by weight of the total weight of the dispersion.

### (Evaluation of swelling property of talc)

In 100 mL of water in a 100-mL measuring cylinder, 2.0 g of the talc powder ("Talc GAT-40" from Nippon Talc Co., Ltd.) which was the same as that used in the process "Preparation of non-swelling clay mineral dispersion" was added by portions to sediment spontaneously. After one-hour standing from the completion of addition, the apparent volume of the swelling clay mineral was read, and the swelling force was found to be 2 mL/2 g.

### (Preparation of dispersion for water vapor barrier films)

A homogeneous dispersion for water vapor barrier films was prepared in the same manner as in Example 6, except that a 114.0 g portion of the swelling clay mineral dispersion and a 37.0 g portion of the non-swelling clay mineral dispersion, both of which were prepared in the process "Preparation of dispersion for water vapor barrier films" in Example 6, were used. The phyllosilicate mineral content of the dispersion was 59.9% by weight of the total of the nonvolatile component, and the swelling clay mineral content was 56.0% by weight of the total weight of the phyllosilicate mineral.

### (Formation of film)

An 80 µm thick water vapor barrier film made of talc, montmorillonite, and a polyimide resin was formed in the same manner as in the process "Formation of film" in Example 6, except that the dispersion for water vapor barrier films obtained above was used. The phyllosilicate mineral content of the film was 59.9% by weight of the total weight, and the swelling clay mineral content was 56.0% by weight of the total weight of the phyllosilicate mineral.

### (Example 9)

### (Preparation of non-swelling clay mineral dispersion)

A homogeneous non-swelling clay mineral dispersion was prepared in the same manner as in Example 6, except that 8.0 g of talc "Talc MS-K" from Nippon Talc Co., Ltd.) and 30.0 g of the 18.6% by weight solution of a polyamide acid in N-methyl-2-pyrrolidone ("U-Varnish A" from Ube Industries, Ltd.) were used in the process "Preparation of non-swelling clay mineral dispersion" in Example 6. The talc content of the dispersion was 58.8% by weight of the total of the nonvolatile component, and the nonvolatile component content was 35.8% by weight of the total weight of the dispersion.

### (Preparation of dispersion for water vapor barrier films)

A homogeneous dispersion for water vapor barrier films was prepared in the same manner as in Example 6, except that a 45.0 g portion of the swelling clay mineral dispersion and a 19.0 g portion of the non-swelling clay mineral dispersion, both of which were prepared in the process "Preparation of dispersion for water vapor barrier films" in Example 6, were used. The phyllosilicate mineral content of the dispersion was 68.2% by weight of the total of the nonvolatile component, and the swelling clay mineral content was 33.3% by weight of the total weight of the phyllosilicate mineral.

### (Formation of film)

A 90 µm thick water vapor barrier film made of talc, montmorillonite, and a polyimide resin was formed in the same manner as in the process "Formation of film" in Example 6, except that the dispersion for water vapor barrier films obtained above was used. The phyllosilicate mineral content of the film was 68.2% by weight of the total weight, and the swelling clay mineral content was 33.3% by weight of the total weight of the phyllosilicate mineral.

### (Example 10)

### (Preparation of dispersion for water vapor barrier films)

A homogeneous dispersion for water vapor barrier films was prepared in the same manner as in Example 6, except that a 76.0 g portion of the swelling clay mineral dispersion prepared in the process "Preparation of dispersion for water vapor barrier films" in Example 6 and a 19.0 g portion of the non-swelling clay mineral dispersion of Example 9 were used. The phyllosilicate mineral content of the dispersion was 72.6% by weight of the total of the nonvolatile component, and the swelling clay mineral content was 46.0% by weight of the total weight of the phyllosilicate mineral.

### (Formation of film)

A 100 µm thick water vapor barrier film made of talc, montmorillonite, and a polyimide resin was obtained in the same manner as in the process "Formation of film" in Example 6, except that the dispersion for water vapor barrier films obtained above was used. The phyllosilicate mineral content of the film was 72.6% by weight of the total weight, and the swelling clay mineral content was 46.0% by weight of the total weight of the phyllosilicate mineral.

### (Example 11)

### (Preparation of non-swelling clay mineral dispersion)

A homogeneous non-swelling clay mineral dispersion was prepared in the same manner as in Example 6, except that 4.0 g of kaolin ("XP01-6100" from IMERYS, layer charge: 0, average particle size: 1 µm) was used instead of talc ("Talc MS-K" from Nippon Talc Co., Ltd.) in the process "Preparation of non-swelling clay mineral dispersion" in Example 6. The kaolin content of the dispersion was 39.6% by weight of the total of the nonvolatile component, and the nonvolatile component content was 27.3% by weight of the total weight of the dispersion.

### (Evaluation of swelling property of kaolin)

In 100 mL of water in a 100-mL measuring cylinder, 2.0 g of the kaolin powder ("XP01-6100" from IMERYS) which was the same as that used in the process "Preparation of non-swelling clay mineral dispersion" was added by portions to sediment spontaneously. After one-hour standing from the completion of addition, the apparent volume of the swelling clay mineral was read, and the swelling force was found to be 2 mL/2 g.

### (Formation of film)

A 100 µm thick water vapor barrier film made of kaolin, montmorillonite, and a polyimide resin was obtained in the same manner as in the process "Formation of film" in Example 6, except that the dispersion for water vapor barrier films obtained above was used. The phyllosilicate mineral content of the film was 53.4% by weight of the total weight, and the swelling clay mineral content was 42.9% by weight of the total weight of the phyllosilicate mineral.

### (Example 12)

### (Preparation of non-swelling clay mineral dispersion)

A homogeneous non-swelling clay mineral dispersion was prepared in the same manner as in Example 6, except that 4.0 g of non-swelling mica ("SJ-010" from YAMAGUCHI MICA CO., LTD., layer charge: 0.6 to 1.0, average particle size: 10 µm) was used instead of talc ("Talc MS-K" from Nippon Talc Co., Ltd.) in the process "Preparation of non-swelling clay mineral dispersion" in Example 6. The non-swelling mica content of the dispersion was 39.6% by weight of the total of the nonvolatile component, and the nonvolatile component content was 27.3% by weight of the total weight of the dispersion.

### (Evaluation of swelling property of non-swelling mica)

In 100 mL of water in a 100-mL measuring cylinder, 2.0 g of the non-swelling mica powder ("SJ-010" from YAMAGUCHI MICA CO., LTD.) which was the same as that used in the process "Preparation of non-swelling clay mineral dispersion" was added by portions to sediment spontaneously. After one-hour standing from the completion of addition, the apparent volume of the swelling clay mineral was read, and the swelling force was found to be 2 mL/2 g.

### (Formation of film)

A 100 µm thick water vapor barrier film made of non-swelling mica, montmorillonite, and a polyimide resin was obtained in the same manner as in the process "Formation of film" in Example 6, except that the dispersion for water vapor barrier films obtained above was used. The phyllosilicate mineral content of the film was 53.4% by weight of the total weight, and the swelling clay mineral content was 42.9% by weight of the total weight of the phyllosilicate mineral.

### (Example 13)

A 45 g portion of the lithium-substituted clay obtained in the process "Production of lithium-substituted clay" in Example 6 and 2955 g of water were charged in a 5000-mL plastic beaker, and stirred into a homogeneous dispersion. This dispersion was transferred to 6 airtight containers (volume: 500 mL), and centrifuged with a centrifuge (High Speed Refrigerated Centrifuge MODEL7000 from KUBOTA Corporation) at 8000 rpm for 10 minutes. The precipitates were removed, and the supernatant was recovered. The supernatant was placed between two polarizers to produce a rainbow image (an image under crossed nicols). This confirmed that it undergoes a liquid crystalline transition. The obtained supernatant was sufficiently dried in an oven, and cracked. Thus, 25 g of a lithium-substituted clay that undergoes a liquid crystalline transition was obtained.

An 85 µm thick water vapor barrier film made of talc, montmorillonite, and a polyimide resin was obtained in the same manner as in the processes from "Preparation of swelling clay mineral gel" to "Formation of film" in Example 6, except that the lithium-substituted clay that undergoes a liquid crystalline transition was used. The phyllosilicate mineral content of the film was 53.4% by weight of the total weight, and the swelling clay mineral content was 42.9% by weight of the total weight of the phyllosilicate mineral.

### (Example 14)

A 100 µm thick water vapor barrier film made of talc, montmorillonite, and a polyimide resin was obtained in the same manner as in the processes from the first process to "Formation of film" in Example 7, except that the lithium-substituted clay of Example 13 that undergoes a liquid crystalline transition was used. The phyllosilicate mineral content of the film was 59.9% by weight of the total weight, and the swelling clay mineral content was 56.0% by weight of the total weight of the phyllosilicate mineral.

### (Comparative Example 1)

In a plastic airtight container, 4.4 g of talc ("Talc MS-K" from Nippon Talc Co., Ltd.) and 33.0 g of the 18.6% by weight solution of a polyamide acid in N-methyl-2-pyrrolidone ("U-Varnish A" from Ube Industries, Ltd.) were charged, and stirred with the planetary centrifugal mixer ("ARE-310" from THINKY) in the mixing mode (2000 rpm) for 10 minutes, and then in the deaeration mode (2200 rpm) for 10 minutes. In this manner, a homogeneous non-swelling clay mineral dispersion was prepared. The talc content of the dispersion was 41.8% by weight of the total of the nonvolatile component, and the nonvolatile component content was 28.2% by weight of the total weight of the dispersion.

An 80 µm thick water vapor barrier film free of swelling clay minerals was formed in the same manner as in Example 1, except that no swelling clay mineral dispersion was used, and that the dispersion was applied to a thickness of 400 µm with a doctor blade. The phyllosilicate mineral content of the film was 41.8% by weight of the total weight.

### (Comparative Example 2)

The swelling clay mineral gel prepared in Example 1 was used without being subjected to the process for preparing a swelling clay mineral dispersion. Specifically, in a plastic airtight container, 4.4 g of talc ("Talc MS-K" from Nippon Talc Co., Ltd.), 33.0 g of the 18.6% by weight solution of a polyamide acid in N-methyl-2-pyrrolidone ("U-Varnish A" from Ube Industries, Ltd.), 38.5 g of N-methyl-2-pyrrolidone, and 11.0 g of the swelling clay mineral gel were charged, and stirred with the planetary centrifugal mixer ("ARE-310" from THINKY) in the mixing mode (2000 rpm) for 10 minutes, and then in the deaeration mode (2200 rpm) for 10 minutes. The resulting dispersion for water vapor barrier films contained aggregates, and namely was not homogeneous. Therefore, it could not be used to form films.

### (Comparative Example 3)

A dispersion for water vapor barrier films free of non-swelling clay minerals was obtained by charging a 120 g portion of the swelling clay mineral dispersion prepared in Example 1, 4.8 g of the 18.6% by weight solution of a polyamide acid in N-methyl-2-pyrrolidone ("U-Varnish A" from Ube Industries, Ltd.) in a plastic airtight container, and stirring them with the planetary centrifugal mixer ("ARE-310" from THINKY) in the mixing mode (2000 rpm) for 10 minutes, and then in the deaeration mode (2200 rpm) for 10 minutes.

The obtained dispersion was applied with a doctor blade to a thickness of 2000 µm, and dried in the same manner as in Example 1. The dried film had many cracks, and was not homogeneous. The thickness of the dried film was 40 µm which is the same as that before the baking.

### (Comparative Example 4)

### (Preparation of non-swelling clay mineral dispersion)

A homogeneous dispersion was prepared in the same manner as in Example 1, except that a 50.0 g portion of the non-swelling clay mineral dispersion prepared in Example 5 and a 25.0 g portion of the swelling clay mineral dispersion prepared in the process "Preparation of dispersion for water vapor barrier films" in Example 1 were used. The phyllosilicate mineral content of the dispersion was 23.7% by weight of the total of the nonvolatile component, and the swelling clay mineral content was 20.2% by weight of the total weight of the phyllosilicate mineral.

An 80 µm thick film made of talc, montmorillonite, and a polyimide resin was formed in the same manner as in the process "Formation of film" in Example 1. The phyllosilicate mineral content of the film was 23.7% by weight of the total weight, and the swelling clay mineral content was 20.2% by weight of the total weight of the phyllosilicate mineral.

### (Comparative Example 5)

### (Preparation of non-swelling clay mineral dispersion)

A homogeneous non-swelling clay mineral dispersion was prepared by charging 25.0 g of talc ("Talc MS-K" from Nippon Talc Co., Ltd.), 15.0 g of the 18.6% by weight solution of a polyamide acid in N-methyl-2-pyrrolidone ("U-Varnish A" from Ube Industries, Ltd.), and 18.0 g of N-methyl-2-pyrrolidone in a plastic airtight container, and stirring them with the planetary centrifugal mixer ("ARE-310" from THINKY) in the mixing mode (2000 rpm) for 10 minutes. The talc content of the dispersion was 89.9% by weight of the total of the nonvolatile component, and the nonvolatile component content was 47.9% by weight of the total weight of the dispersion.

A homogeneous dispersion was prepared in the same manner as in Example 1, except that a 40.0 g portion of the non-swelling clay mineral dispersion prepared above and a 40.0 g portion of the swelling clay mineral dispersion prepared in the process "Preparation of dispersion for water vapor barrier films" in Example 1 were used. The phyllosilicate mineral content of the dispersion was 90.9% by weight of the total of the nonvolatile component, and the swelling clay mineral content was 9.4% by weight of the total weight of the phyllosilicate mineral.

In order to form a 90 µm thick water vapor barrier film made of talc, montmorillonite, and a polyimide resin with a phyllosilicate mineral content of 90.9% by weight of the total weight and a swelling clay mineral content of 9.4% by weight of the total weight of the phyllosilicate mineral, the same process as "Formation of film" in Example 1 was performed, except that the dispersion was applied with a doctor blade to a thickness of 750 µm. The dried film was easily cracked, and was not homogeneous.

### (Comparative Example 6)

In a plastic airtight container, 2.2 g of talc ("Talc MS-K" from Nippon Talc Co., Ltd.), 3.4 g of non-swelling mica ("SJ-010" from YAMAGUCHI MICA CO., LTD.), and 30.0 g of the 18.6% by weight solution of a polyamide acid in N-methyl-2-pyrrolidone ("U-Varnish A" from Ube Industries, Ltd.) were charged, and stirred with the planetary centrifugal mixer ("ARE-310" from THINKY) in the mixing mode (2000 rpm) for 10 minutes, and then in the deaeration mode (2200 rpm) for 10 minutes. In this manner, a homogeneous non-swelling clay mineral dispersion was prepared. The non-swelling clay mineral content of the dispersion was 50.0% by weight of the total of the nonvolatile component, and the nonvolatile component content was 31.4% by weight of the total weight of the dispersion.

A 65 µm thick water vapor barrier film free of swelling clay minerals was formed in the same manner as in Example 1, except that no swelling clay mineral dispersion was used, and that the dispersion was applied to a thickness of 400 µm with a doctor blade. The phyllosilicate mineral content of the film was 50.0% by weight of the total weight.

### <Evaluation>

The water vapor barrier films obtained in Examples 1 to 14 and Comparative Examples 1, 4, and 6 were evaluated as follows. Tables 4 to 6 show the results.

Since no film could be formed in Comparative Example 2, this example could not be evaluated. The films of Comparative Examples 3 and 5 were also not evaluated because they had cracks.

### (Water vapor permeability)

By the gas chromatography in accordance with JIS K 7126, method A (differential pressure method), the water vapor barrier films were measured for water vapor permeability at 40°C and 90%RH using gas/vapor permeability testing systems which are capable of measuring the gas or water vapor permeability and moisture permeability. The following gas/vapor permeability testing systems were used: GTR-30XA (GTR Tec Corporation) for Examples 1 to 5 and Comparative Examples 1, 4, and 6; and DELTAPERM (Technolox) for Examples 6 to 14.

### (Flammability evaluation by VTM test)

The UL-94 thin material vertical burning test (VTM test) was performed on the produced water vapor barrier films.

For each item of evaluation shown in Table 1, five specimens (length: about 200 mm, width; 50 mm) were prepared from each film. The size of flame was 20 mm.

A specimen was contacted with flame for 3 seconds, and the afterflame time was measured after the flame contact. Simultaneously with the flame extinction, the specimen was brought into contact with flame for 3 seconds for the second time, and the afterflame time was measured in the same manner as for the first measurement. Also, whether or not the cotton placed below the specimen was ignited by burning cinders fallen from the specimen was observed. The benchmark was at a position 125 mm from the bottom of the specimen, and the marking cotton was placed 300 mm below the bottom of the specimen.

VTM-0 is the highest level of flame retardancy among the ranks of the VYM test, followed by the lower flame retardancy levels of VTM-1 and VTM-2. If a specimen was not evaluated as having flammability corresponding to any of the levels from VTM-0 to VTM-2, the specimen was evaluated as "failed".

### (Flex resistance)

The obtained water vapor barrier films were subjected to a flex resistance test (the cylindrical mandrel method) in accordance with JIS-K5600-5-1. The test was performed on each specimen using 1- to 5-mm-diameter mandrels from a larger-diameter mandrel to a smaller-diameter mandrel to determine the mandrel diameter at which cracking or splitting of the film occurred. A film which did not crack with a 1-mm mandrel was ranked as ≤ 1 mm.

**[Table 4]**

| | | | | Example 1 | Example 2 | Example 3 | Example 4 | Example 5 |
|---|---|---|---|---|---|---|---|---|
| | Composition (parts by weight) | Non-swelling clay mineral | Talc (Swelling force 2 mL/2 g) ("Talc MS-K" from Nippon Talc Co., Ltd.) | 4.4 | 4.4 | 4.4 | 4.4 | 2.2 |
| | | Swelling clay mineral | Li-substituted montmorillonite (swelling force 85 mL/2 g) | 1.1 | 2.2 | 3.3 | 4.4 | 2.2 |
| Dispersion for water vapor barrier films | | Synthetic resin precursor | Polyamide acid | 6. 1 | 6. 1 | 6. 1 | 6. 1 | 8.9 |
| | | Dispersion medium | N-Methyl-2-pyrrolidone | 65.4 | 103.9 | 142. 4 | 180.9 | 115. 9 |
| | Phyllosilicate mineral content in nonvolatile component (% by weight) | | | 47.4 | 52.0 | 55. 8 | 59. 1 | 33.1 |
| | Swelling clay mineral content in phyllosilicate mineral (% by weight) | | | 20.0 | 33.3 | 42. 9 | 50.0 | 50. 0 |
| | Composition (parts by weight) | Non-swelling clay mineral | Talc (Swelling force 2 mL/2 g) ("Talc MS-K" from Nippon Talc Co., Ltd.) | 4.4 | 4.4 | 4.4 | 4.4 | 2. 2 |
| | | Swelling clay mineral | Li-substituted montmorillonite (swelling force 85 mL/2 g) | 1. 1 | 2.2 | 3. 3 | 4.4 | 2.2 |
| | | Synthetic resin | Polyimide resin | 6. 1 | 6. 1 | 6.1 | 6. 1 | 8. 9 |
| Water vapor barrier film | Phyllosilicate mineral content in water vapor barrier film (% by weight) | | | 47.4 | 52.0 | 55. 8 | 59. 1 | 33. 1 |
| | Swelling clay mineral content in phyllosilicate mineral (% by weight) | | | 20.0 | 33. 3 | 42. 9 | 50.0 | 50.0 |
| | Appearance of film | | | Homogeneous | Homogeneous | Homogeneous | Homogeneous | Homogeneous |
| | Thickness of film (*µ* m) | | | 90 | 110 | 90 | 70 | 85 |
| Evaluation | Flame retardancy | | VTM test | VTM-0 passed | VTM-0 passed | VTM-0 passed | VTM-0 passed | VTM-0 passed |
| | Flex resistance | | Mandrel diameter (mm) | 9 | 10 | 10 | 10 | 8 |
| | Water vapor permeability (g/m²·day) | | | 0.2 | 0.04 | <0.01 | <0. 01 | 0.4 |

**[Table 5]**

| | | | | Example 6 | Example 7 | Example 8 | Example 9 | Example 10 | Example 11 | Example 12 | Example 13 | Example 14 |
|---|---|---|---|---|---|---|---|---|---|---|---|---|
| | | | Talc (Swelling force 2mL/2g) ("Talc MS-K" from Nippon Talc Co-Ltd.) | 4.0 | 4. 0 | - | 4.0 | 4.0 | - | - | 4.0 | 4.0 |
| | | | Talc (Swelling force 2 mL/2 g) ("Talc GAT-40" from Nippon Talc Co., Ltd.) | - | - | 4.0 | - | - | - | - | - | - |
| | | Non-swelling clay mineral | Kaolin (swelling force 2mL/2g) ("XP01-6100" from IMERYS) | - | - | - | - | - | 4.0 | - | - | - |
| | Composition (parts by weight) | | Non-swelling mica (swelling force 2 mL/2 g) ("SJ-010" from YAMAGUCHI MICA CO., LTD.) | - | - | - | - | - | - | 4.0 | - | - |
| Dispersion for water vapor barrier films | | Swelling clay mineral | Li-substituted montmorillonite (swelling force 90 mL/2 g) | 3.0 | 5.1 | 5.1 | 2.0 | 3.4 | 3.0 | 3.0 | 3.0 | 5.1 |
| | | Synthetic resin precursor | Polyamide acid | 6.1 | 6.1 | 6.1 | 2.8 | 2.8 | 6.1 | 6.1 | 6.1 | 6.1 |
| | | Dispersion medium | N-Methyl-2-pyrrolidone | 79.8 | 115.6 | 115.6 | 47.2 | 71.3 | 79.8 | 79.8 | 79.8 | 115.6 |
| | Phyllosilicate mineral content in nonvolatile component (% by weight) | | | 53.4 | 59.9 | 59. 9 | 68.2 | 72.6 | 53.4 | 53.4 | 53.4 | 59. 9 |
| | Swelling clay mineral content in phyllosilicate mineral (% by weight) | | | 42.9 | 56.0 | 56.0 | 33.3 | 46.0 | 42.9 | 42.9 | 42.9 | 56.0 |
| | | | Talc (Swelling force 2mL/2g) ("Talc MS-K" from Nippon Talc Co., Ltd.) | 4.0 | 4.0 | - | 4.0 | 4.0 | - | - | 4.0 | 4.0 |
| | | | Talc (Swelling force 2 mL/2 g) ("Talc GAT-40" from Nippon Talc Co., Ltd.) | - | - | 4.0 | - | - | - | - | - | - |
| | Composition (parts by weight) | Non-swelling clay mineral | Kaolin (swelling force 2mL/2g) ("XP01-6100" from IMERYS) | - | - | - | - | - | 4.0 | - | - | - |
| Water vapor barrier film | | | Non-swelling mica (swelling force 2 mL/2 g) ("SJ-010" from YAMAGUCHI MICA CO., LTD.) | - | - | - | - | - | - | 4.0 | - | - |
| | | Swelling clay mineral | Li-substituted montmorillonite (swelling force 90 mL/2 g) | 3.0 | 5.1 | 5.1 | 2.0 | 3.4 | 3.0 | 3.0 | 3.0 | 5.1 |
| | | Synthetic resin | Polyimide resin | 6.1 | 6. 1 | 6. 1 | 2.8 | 2.8 | 6. 1 | 6.1 | 6.1 | 6.1 |
| | Phyllosilicate mineral content in water vapor barrier film (% by weight) | | | 53.4 | 59.9 | 59.9 | 68.2 | 72. 6 | 53.4 | 53.4 | 53.4 | 59. 9 |
| | Swelling clay mineral content in phyllosilicate mineral (% by weight) | | | 42.9 | 56.0 | 56.0 | 33.3 | 46.0 | 42.9 | 42.9 | 42.9 | 56.0 |
| | Appearance of film | | | Homogeneous | Homogeneous | H omogeneous | Homogeneous | Homogeneous | Homogeneous | Homogeneous | Homogeneous | Homogeneous |
| | Thickness of film (µ m) | | | 80 | 100 | 80 | 90 | 100 | 100 | 100 | 85 | 100 |
| | Flame retardancy | | VTM test | VTM-0 passed | VTM-O passed | VTM-O passed | VTM-O passed | VTM-O passed | VTM-O passed | VTM-O passed | VTM-O passed | VTM-O passed |
| Evaluation | Flex resistance | | Mandrel diameter (mm) | 10 | 11 | 11 | 10 | 12 | 15 | 15 | 7 | 8 |
| | Water vapor permeability (g/m²· day) | | | 0.078 | 0.050 | 0.025 | 0.037 | 0.013 | 0.0032 | 0.0030 | 0.031 | 0.032 |

**[Table 6]**

| | | | | Comparative Example 1 | Comparative Example 2 | Comparative Example 3 | Comparative Example 4 | Comparative Example 5 | Comparative Example 6 |
|---|---|---|---|---|---|---|---|---|---|
| | Composition (parts by weight) | Non-swelling clay mineral | Talc (Swelling force 2mL/2g) ("Talc MS-K" from Nippon Talc Co., Ltd.) | 4.4 | Aggregates occurred | - | 2.2 | 17.2 | 2. 2 |
| | | | Non-swelling mica (swelling force 2 mL/2 g) ("SJ-010" from YAMAGUCHI MICA CO., LTD.) | - | | - | - | - | 3.4 |
| | | Swelling clay mineral | Li-substituted montmorillonite (swelling force 85 mL/2 g) | - | | 2.7 | 0.6 | 1. 8 | - |
| Dispersion for water vapor barrier films | | Synthetic resin precursor | Polyamide acid | 6.1 | | 0.9 | 8.9 | 1.9 | 5. 6 |
| | | Dispersion medium | N-Methyl-2-pyrrolidone | 26.9 | | 97.2 | 58. 3 | 52.0 | 24.4 |
| | Phyllosilicate mineral content in nonvolatile component (% by weight) | | | 41.9 | | 75.0 | 23.9 | 90. 9 | 50. 0 |
| | Swelling clay mineral content in phyllosilicate mineral (% by weight) | | | - | | 100 | 21.4 | 9. 5 | - |
| | Composition (parts by weight) | Non-swelling clay mineral | Talc (Swelling force 2mL/2g) ("Talc MS-K" from Nippon Talc Co., Ltd.) | 4.4 | Film could not be formed | - | 2.2 | 17.2 | 2. 2 |
| | | | Non-swelling mica (swelling force 2 mL/2 g) ("SJ-010" from YAMAGUCHI MICA CO., LTD.) | - | | - | - | - | 3.4 |
| Water vapor barrier film | | Swelling clay mineral | Li-substituted montmorillonite (swelling force 85 mL/2 g) | - | | 2.7 | 0.6 | 1.8 | - |
| | | Synthetic resin | Polyimide resin | 6.1 | | 0.9 | 8.9 | 1. 9 | 5. 6 |
| | Phyllosilicate mineral content in water vapor barrier film (% by weight) | | | 41.9 | | 75.0 | 23. 9 | 90.9 | 50.0 |
| | Swelling clay mineral content in phyllosilicate mineral (% by weight) | | | - | | 100 | 21.4 | 9.5 | - |
| | Appearance of film | | | Homogeneous | | Cracked | Homogeneous | Easily cracked | Homogeneous |
| | Thickness of film (*µ*m) | | | 80 | | 40 | 80 | 90 | 65 |
| Evaluation | Flame retardancy | | VTM test | VTM-O passed | - | - | VTM-O passed | - | VTM-O passed |
| | Flex resistance | | Mandrel diameter (mm) | <1 | - | - | 2 | - | 1 |
| | Water vapor permeability (g/m²·day) | | | 1.2 | - | - | 1.3 | - | 1. 1 |

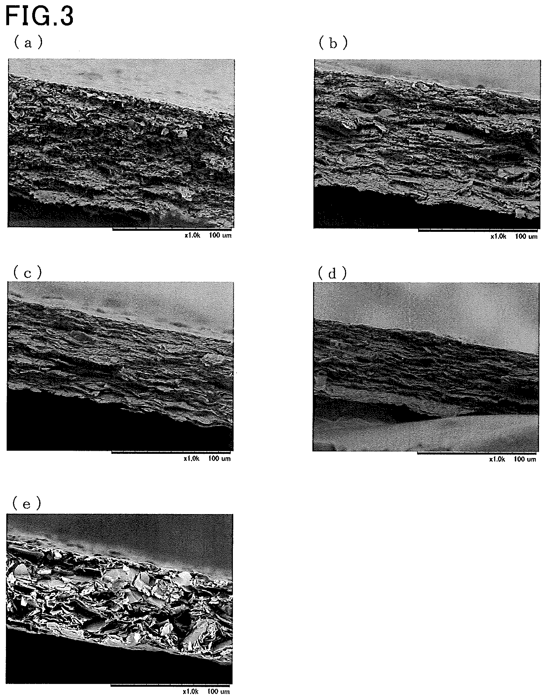

Fig. 3 shows electron microscopic photographs of cross sections of films produced in Examples 1 to 4 and Comparative Example 1. Fig. 3(a) shows the cross section of the film formed in Example 1, Fig. 3(b) shows the cross section of the film formed in Example 2, Fig. 3(c) shows the cross section of the film formed in Example 3, Fig. 3(d) show the cross section of the film formed in Example 4, and Fig. 3(e) shows the cross section of the film formed in Comparative Example 1.

As seen in Figs. 3, a clear layered structure can be observed in the photograph of Example 1 in which 20% by weight of the swelling clay mineral was used whereas a clear layered structure cannot be observed in the photograph of Comparative Example 1 in which only the non-swelling clay mineral was used.

Additionally, it was revealed that the use of a swelling clay mineral at a higher ratio results in a better layered structure as seen in the photographs of Examples 2 to 4.

### INDUSTRIAL APPLICABILITY

The present invention provides a water vapor barrier film having good flexibility, good moisture resistance, and high mechanical strength. The present invention also provides a dispersion for water vapor barrier films which is intended to be used to produce the water vapor barrier film, a method for producing the water vapor barrier film, a solar cell back sheet incorporating the water vapor barrier film, and a solar cell incorporating the water vapor barrier film or the solar cell back sheet.

Because of its sufficient mechanical strength and good flexibility, the water vapor barrier film of the present invention can be used for various products, for example, as a material for electronic components or machine components, such as a film for electronic devices (e.g. a substrate film for LCDs, a substrate film for organic light-emitting display, a substrate film for electronic paper, a sealing film for electronic devices , a PDP film, a LED film, a film for IC tags, a back sheet for solar cells, a protective film for solar cells); a flexible film for optical communication devices or other electronic devices; a substrate film for functional films of various types (e.g. a separation membrane for fuel cells, a sealing film for fuel cells); a film for food packaging, a film for drink packaging, a film for medicine packaging; a film for daily commodity packaging, a film for industrial product packaging, and a packaging film for other products of any types; and a gas barrier seal tape against gas species including carbon dioxide and hydrogen, a multi-layer packaging film, an anti-oxidation coating, an anticorrosion coating, a weatherproof coating, an incombustible coating, a heat-resistant coating, and a chemical-resistant coating. The present invention provides a new material in these fields, contributing to development to new technologies.

### REFERENCE SIGNS LIST

- 1: Solar cell
- 2: Solar cell device
- 3: Sealing material
- 4: Light transmissive substrate
- 5: Solar cell back sheet
- 6: Water vapor barrier film

## Claims

1. A water vapor barrier film comprising:
a phyllosilicate mineral; and
a synthetic resin,
wherein the phyllosilicate mineral comprises a non-swelling clay mineral and a swelling clay mineral,
the phyllosilicate mineral is present in an amount of not less than 30% by weight and not more than 90% by weight of the total weight of the water vapor barrier film, and
the water vapor barrier film has a water vapor permeability, measured at 40°C and 90%RH, of not more than 0.5 g/m²·day,
the non-swelling clay mineral has a swelling force of less than 5 mL/2 g and the swelling clay mineral has a swelling force of not less than 5 mL/2 g, the swelling force being measured according to the measurement method as set out in the description,
the swelling clay mineral is present in an amount of not less than 2% by weight and not more than 80% by weight of the total weight of the phyllosilicate mineral, and
the synthetic resin is a heat-resistant synthetic resin.

2. The water vapor barrier film according to claim 1,
wherein the non-swelling clay mineral is at least one selected from the group consisting of talc, kaolin, and pyrophyllite.

3. The water vapor barrier film according to claim 1 or 2,
wherein the swelling clay mineral is at least one selected from the group consisting of montmorillonite, saponite, hectorite, and stevensite.

4. The water vapor barrier film according to claim 1, 2 or 3,
wherein the heat-resistant synthetic resin is a polyimide resin, polyamide-imide resin, fluororesin, polyphenylene sulfide resin, polysulfone resin, polyarylate resin, polyethersulfone resin, polyetherimide resin, polyetheretherketone resin, polybenzooxazole resin or polybenzimidazole resin.

5. The water vapor barrier film according to claim 1, 2, 3 or 4,
wherein the heat-resistant synthetic resin is a polyimide resin and/or a polyamide-imide resin.

6. The water vapor barrier film according to claim 1, 2, 3, 4 or 5,
wherein the water vapor barrier film has a thickness of 10 µm or more.

7. A dispersion for water vapor barrier films intended to be used to produce the water vapor barrier film according to claim 1, 2, 3, 4, 5 or 6, the dispersion comprising:
a dispersion medium; and
a nonvolatile component comprising a phyllosilicate mineral and at least one of a synthetic resin and a synthetic resin precursor,
the phyllosilicate mineral being present in an amount of not less than 30% by weight and not more than 90% by weight of the total weight of the nonvolatile component,
the phyllosilicate mineral comprising a non-swelling clay mineral and a swelling clay mineral,
the non-swelling clay mineral having a swelling force of less than 5 mL/2 g and the swelling clay mineral having a swelling force of not less than 5 mL/2 g, the swelling force being measured according to the measurement method as set out in the description,
the swelling clay mineral being present in an amount of not less than 2% by weight and not more than 80% by weight of the total weight of the phyllosilicate mineral.

8. A method for producing the water vapor barrier film according to claim 1, 2, 3, 4, 5 or 6, the method comprising:
step 1 of preparing a swelling clay mineral dispersion containing a dispersion medium and a swelling clay mineral;
step 2 of preparing a non-swelling clay mineral dispersion containing a dispersion medium, a non-swelling clay mineral, and at least one of a synthetic resin and a synthetic resin precursor;
step 3 of mixing the swelling clay mineral dispersion and the non-swelling clay mineral dispersion, thereby providing the dispersion for water vapor barrier films according to claim 7;
step 4 of spreading the obtained dispersion for water vapor barrier films on a substrate, and leaving it standing; and
step 5 of forming a film by removing the dispersion medium from the dispersion for water vapor barrier films spread on the substrate
wherein the non-swelling clay mineral has a swelling force of less than 5 mL/2 g and the swelling clay mineral has a swelling force of not less than 5 mL/2 g, the swelling force being measured according to the measurement method as set out in the description.

9. The method according to claim 8,
wherein the dispersion medium is removed at a temperature of not higher than 150°C in step 5.

10. The method according to claim 8 or 9,
wherein the substrate is made of glass, polyethylene terephthalate, polyimide, polyethylene, or polypropylene.

11. A solar cell back sheet comprising the water vapor barrier film according to claim 1, 2, 3, 4, 5 or 6.

12. A solar cell comprising the water vapor barrier film according to claim 1, 2, 3, 4, 5 or 6, or the solar cell back sheet according to claim 11.

## Patentansprüche

1. Wasserdampfbarrierefilm, umfassend:
ein Phyllosilikatmineral; und
ein Kunstharz,
worin das Phyllosilikatmineral ein nicht-quellendes Tonmineral und ein quellendes Tonmineral umfasst;
wobei das Phyllosilikatmineral in einem Anteil von nicht weniger als 30 Gew.-% und nicht mehr als 90 Gew.-% des Gesamtgewichts des Wasserdampfbarrierefilms vorhanden ist, und
wobei der Wasserdampfbarrierefilm eine Wasserdampfpermeabilität, die bei 40°C und 90%-RH gemessen wird, von nicht mehr als 0,5 g/m² pro Tag aufweist,
wobei das nicht-quellende Tonmineral ein Quellvermögen von weniger als 5 mU2 g aufweist, und das quellende Tonmineral ein Quellvermögen von nicht weniger als 5 mL/2 g aufweist, wobei das Quellvermögen gemäß dem in der Beschreibung dargelegten Messverfahren gemessen wird,
wobei das quellende Tonmineral in einem Anteil von nicht weniger als 2 Gew.-% und nicht mehr als 80 Gew.-% des Gesamtgewichts des Phyllosilikatminerals vorhanden ist, und
wobei das Kunstharz ein hitzebeständiges Kunstharz ist.

2. Wasserdampfbarrierefilm gemäß Anspruch 1,
worin das nicht-quellende Tonmineral mindestens eines ist, das aus der aus Talk, Kaolin und Pyrophyllit bestehenden Gruppe ausgewählt ist.

3. Wasserdampfbarrierefilm gemäß Anspruch 1 oder 2,
worin das quellende Tonmineral mindestens eines ist, das aus der aus Montmorillonit, Saponit, Hectorit und Stevensit bestehenden Gruppe ausgewählt ist.

4. Wasserdampfbarrierefilm gemäß Anspruch 1, 2 oder 3,
worin das hitzebeständige Kunstharz ein Polyimidharz, ein Polyamid-Imidharz, ein Fluorharz, ein Polyphenylensulfidharz, ein Polysulfonharz, ein Polyarylatharz, ein Polyethersulfonharz, ein Polyehterimidharz, ein Polyetheretherketonharz, ein Polybenzooxazolharz oder ein Polybenzimidazolharz ist.

5. Wasserdampfbarrierefilm gemäß Anspruch 1, 2, 3 oder 4,
worin das hitzebeständige Kunstharz ein Polyimidharz und/oder ein Polyamid-Imidharz ist.

6. Wasserdampfbarrierefilm gemäß Anspruch 1, 2, 3, 4 oder 5,
worin der Wasserdampfbarrierefilm eine Dicke von 10 µm oder mehr aufweist.

7. Dispersion für Wasserdampfbarrierefilme, die dazu bestimmt sind, zur Herstellung des Wasserdampfbarrierefilms gemäß Anspruch 1, 2, 3, 4, 5 oder 6 verwendet zu werden, wobei die Dispersion Folgendes umfasst:
ein Dispersionsmedium; und
eine nicht-flüchtige Komponente, die ein Phyllosilikatmineral und mindestens eines von einem Kunstharz und einem Kunstharzvorläufer umfasst,
wobei das Phyllosilikatmineral in einem Anteil von nicht weniger als 30 Gew.-% und nicht mehr als 90 Gew.-% des Gesamtgewichts der nicht-flüchtigen Komponente vorhanden ist,
wobei das Phyllosilikatmineral ein nicht-quellendes Tonmineral und ein quellendes Tonmineral umfasst,
wobei das nicht-quellende Tonmineral ein Quellvermögen von weniger als 5 mU2 g aufweist, und das quellende Tonmineral ein Quellvermögen von nicht weniger als 5 mL/2 g aufweist, wobei das Quellvermögen gemäß dem in der Beschreibung dargelegten Messverfahren gemessen wird,
wobei das quellende Tonmineral in einem Anteil von nicht weniger als 2 Gew.-% und nicht mehr als 80 Gew.-% des Gesamtgewichts des Phyllosilikatminerals vorhanden ist.

8. Verfahren zur Herstellung des Wasserdampfbarrierefilms gemäß Anspruch 1, 2, 3, 4, 5 oder 6, wobei das Verfahren Folgendes umfasst:
einen Schritt 1 des Herstellens einer Quelltonmineraldispersion, die ein Dispersionsmedium und ein quellendes Tonmineral enthält;
einen Schritt 2 des Herstellens einer Nicht-Quelltonmineraldispersion, die ein Dispersionsmedium, ein nicht-quellendes Tonmineral und mindestens eines von einem Kunstharz und einem Kunstharzvorläufer enthält;
einen Schritt 3 des Mischens der Quelltonmineraldispersion und der Nicht-Quelltonmineraldispersion, wodurch die Dispersion für Wasserdampfbarrierefilme gemäß Anspruch 7 bereitgestellt wird;
einen Schritt 4 des Verteilens der erhaltenen Dispersion für Wasserdampfbarrierefilme auf einem Substrat, und des Stehenlassens derselben; und
einen Schritt 5 des Ausbildens eines Films durch Entfernen des Dispersionsmediums aus der auf dem Substrat verteilten Dispersion für Wasserdampfbarrierefilme,
worin das nicht-quellende Tonmineral ein Quellvermögen von weniger als 5 mU2 g aufweist, und das quellende Tonmineral ein Quellvermögen von nicht weniger als 5 mL/2 g aufweist, wobei das Quellvermögen gemäß dem in der Beschreibung dargelegten Messverfahren gemessen wird.

9. Verfahren gemäß Anspruch 8,
worin das Dispersionsmedium bei einer Temperatur von nicht mehr als 150°C in Schritt 5 entfernt wird.

10. Verfahren gemäß Anspruch 8 oder 9,
worin das Substrat aus Glas, Polyethylen-Terephthalat, Polyimid, Polyethylen oder Polyproylen gebildet ist.

11. Solarzellen-Rückseitenfolie, umfassend den Wasserdampfbarrierefilm gemäß Anspruch 1, 2, 3, 4, 5 oder 6.

12. Solarzelle, umfassend den Wasserdampfbarrierefilm gemäß Anspruch 1, 2, 3, 4, 5 oder 6, oder die Solarzellen-Rückseitenfolie gemäß Anspruch 11.

## Revendications

1. Film pare-vapeur d'eau comprenant :
un minéral de phyllosilicate ; et
une résine synthétique,
dans lequel le minéral de phyllosilicate comprend un minéral argileux qui ne gonfle pas et un minéral argileux qui gonfle,
le minéral de phyllosilicate est présent dans une quantité non inférieure à 30% en poids et non supérieure à 90% en poids du poids total du film pare-vapeur d'eau, et
le film pare-vapeur d'eau présente une perméabilité à la vapeur d'eau, mesurée à 40°C et 90% d'humidité relative, non supérieure à 0,5 g/m²·jour,
le minéral argileux qui ne gonfle pas présente une force de gonflement inférieure à 5 mL/2 g et le minéral argileux qui gonfle présente une force de gonflement non inférieure à 5 mL/2 g, la force de gonflement étant mesurée selon le procédé de mesure défini dans la description,
le minéral argileux qui gonfle est présent dans une quantité non inférieure à 2% en poids et non supérieure à 80% en poids du poids total du minéral de phyllosilicate, et
la résine synthétique est une résine synthétique résistante à la chaleur.

2. Film pare-vapeur d'eau selon la revendication 1,
dans lequel le minéral argileux qui ne gonfle pas est au moins choisi parmi le groupe consistant en du talc, du kaolin, et de la pyrophyllite.

3. Film pare-vapeur d'eau selon la revendication 1 ou 2,
dans lequel le minéral argileux qui gonfle est au moins choisi parmi le groupe consistant en de la montmorillonite, de la saponite, de l'hectorite, et de la stevensite.

4. Film pare-vapeur d'eau selon la revendication 1, 2 ou 3,
dans lequel la résine synthétique résistante à la chaleur est une résine de polyimide, une résine de polyamide-imide, une fluororésine, une résine de sulfure de polyphénylène, une résine de polysufone, une résine de polyarylate, une résine de polyéthersulfone, une résine de polyétherimide, une résine de polyéther-éther-cétone, une résine de polybenzooxazole ou une résine de polybenzimidazole.

5. Film pare-vapeur d'eau selon la revendication 1, 2, 3 ou 4,
dans lequel la résine synthétique résistante à la chaleur est une résine de polyimide et/ou une résine de polyamide-imide.

6. Film pare-vapeur d'eau selon la revendication 1, 2, 3, 4 ou 5,
dans lequel le film pare-vapeur d'eau présente une épaisseur de 10 µm ou plus.

7. Dispersion pour films pare-vapeur d'eau destinée à être utilisée pour produire le film pare-vapeur d'eau selon la revendication 1, 2, 3, 4, 5 ou 6, la dispersion comprenant :
un milieu de dispersion ; et
un composant non-volatil comprenant un minéral de phyllosilicate et au moins l'un d'une résine synthétique et d'un précurseur de résine synthétique,
le minéral de phyllosilicate étant présent dans une quantité non inférieure à 30% en poids et non supérieure à 90% en poids du poids total du composant non-volatil,
le minéral de phyllosilicate comprenant un minéral argileux qui ne gonfle pas et un minéral argileux qui gonfle,
le minéral argileux qui ne gonfle pas présentant une force de gonflement inférieure à 5 mL/2 g et le minéral argileux qui gonfle présentant une force de gonflement non inférieure à 5 mL/2 g, la force de gonflement étant mesurée selon le procédé de mesure défini dans la description,
le minéral argileux qui gonfle étant présent dans une quantité non inférieure à 2% en poids et non supérieure à 80% en poids du poids total du minéral de phyllosilicate.

8. Procédé de fabrication du film pare-vapeur d'eau selon la revendication 1, 2, 3, 4, 5, ou 6, le procédé comprenant :
une étape 1 de préparation d'une dispersion de minéral argileux qui gonfle, qui contient un milieu de dispersion et un minéral argileux qui gonfle ;
une étape 2 de préparation d'une dispersion de minéral argileux qui ne gonfle pas, qui contient un milieu de dispersion, un minéral argileux qui ne gonfle pas, et au moins l'un d'une résine synthétique et d'un précurseur de résine synthétique ;
une étape 3 de mélange de la dispersion de minéral argileux qui gonfle et de la dispersion de minéral argileux qui ne gonfle pas, afin d'obtenir la dispersion destinée aux films pare-vapeur d'eau selon la revendication 7 ;
une étape 4 de diffusion de la dispersion obtenue destinée aux fils pare-vapeur d'eau sur un substrat, et de repos de celle-ci ;
une étape 5 de formation d'un film en retirant le milieu de dispersion de la dispersion destinée aux fils pare-vapeur d'eau diffusée sur le substrat,
dans lequel le minéral argileux qui ne gonfle pas présente une force de gonflement inférieure à 5 mL/2 g et le minéral argileux qui gonfle présente une force de gonflement non inférieure à 5 mL/2 g, la force de gonflement étant mesurée selon le procédé de mesure défini dans la description.

9. Procédé selon la revendication 8,
dans lequel le milieu de dispersion est retiré à une température non supérieure à 150°C à l'étape 5.

10. Procédé selon la revendication 8 ou 9,
dans lequel le substrat est composé de verre, de polyéthylène téréphtalate, de polyimide, de polyéthylène, ou de polypropylène.

11. Couche arrière de pile photovoltaïque comprenant le film pare-vapeur d'eau selon la revendication 1, 2, 3, 4, 5 ou 6.

12. Pile photovoltaïque comprenant le film pare-vapeur d'eau selon la revendication 1, 2, 3, 4, 5 ou 6, ou la couche arrière de pile photovoltaïque selon la revendication 11.
